(19) Europäisches Patentamt
European Patent Office
Office européen des brevets

(11) **EP 3 833 993 B1**

(12) **EUROPEAN PATENT SPECIFICATION**

(45) Date of publication and mention
of the grant of the patent:
**18.06.2025  Bulletin 2025/25**

(21) Application number: **19847802.6**

(22) Date of filing: **06.08.2019**

(51) International Patent Classification (IPC):
**G01R 31/367** (2019.01)    **G01R 31/392** (2019.01)

(52) Cooperative Patent Classification (CPC):
**G01R 31/392; G01R 31/367;** Y02E 60/10

(86) International application number:
**PCT/US2019/045205**

(87) International publication number:
**WO 2020/033343 (13.02.2020 Gazette 2020/07)**

(54) **ELECTRODE DIAGNOSTICS FOR LITHIUM ION BATTERY**

ELEKTRODEN-DIAGNOSTIK FÜR LITHIUM-IONEN-BATTERIE

DIAGNOSTIC D'ÉLECTRODE POUR BATTERIE AU LITHIUM-ION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority:  **06.08.2018   US 201862715014 P**

(43) Date of publication of application:
**16.06.2021   Bulletin 2021/24**

(73) Proprietors:
• **The Regents of the University of Michigan**
**Ann Arbor, MI 48109-2590 (US)**
• **Samsung SDI Co., Ltd.**
**Yongin-si, Gyeonggi-do 17085 (KR)**

(72) Inventors:
• **STEFANOPOULOU, Anna, G.**
**Ann Arbor, MI 48103 (US)**
• **LEE, Suhak**
**Ann Arbor, MI 48109-2590 (US)**
• **SIEGEL, Jason, B.**
**Ann Arbor, MI 48103 (US)**
• **LEE, Jang-Woo**
**Ann Arbor, MI 48109-2590 (US)**
• **LEE, Tae-Kyung**
**Ann Arbor, MI 48109-2590 (US)**

(74) Representative: **J A Kemp LLP**
**80 Turnmill Street
London EC1M 5QU (GB)**

(56) References cited:
**US-A1- 2013 314 050      US-A1- 2017 038 436
US-A1- 2017 115 355      US-B2- 9 768 476**

• **LEE SUHAK ET AL: "Beyond Estimating Battery
State of Health: Identifiability of Individual
Electrode Capacity and Utilization", 2018
ANNUAL AMERICAN CONTROL CONFERENCE
(ACC), AACC, 27 June 2018 (2018-06-27), pages
2288 - 2293, XP033386974, DOI: 10.23919/
ACC.2018.8430743**
• **BLOOM I ET AL: "Differential voltage analyses of
high-power, lithium-ion cells - 1. Technique and
application", JOURNAL OF POWER SOURCES,
ELSEVIER, AMSTERDAM, NL, vol. 139, no. 1-2, 4
January 2005 (2005-01-04), pages 295 - 303,
XP004694581, ISSN: 0378-7753, DOI: 10.1016/
J.JPOWSOUR.2004.07.021**

**Description**

BACKGROUND OF THE INVENTION

1. Field of the Invention

This invention relates to a device and method for estimating the state of health in both electrodes of a battery cell using voltage and current measurements in conjunction with reference curves of fresh reference electrode potentials.

2. Description of the Related Art

Li-ion batteries play an important role as energy storage devices in many applications. For example, electric vehicles (EV) require durability and robustness of the battery over their service life of almost ten years. Moreover, safe use and reuse of batteries depend on a thorough understanding of their state of health (SOH). Thus it is essential to develop a method for monitoring the SOH of the battery. The SOH is typically estimated by identifying changes in the battery model's parameters as the battery ages. For example, many efforts have been made to estimate capacity or resistance of the cell as SOH indicators on a cell level (Ref. 2.1-2.4), which affects to predict maximum drive range and peak power capability of EV applications. On the other hand, less attention has been given to individual electrode state of health (eSOH) in the cell, which can provide the detailed information on the degradation status of the battery and help to prevent a dangerous failure.

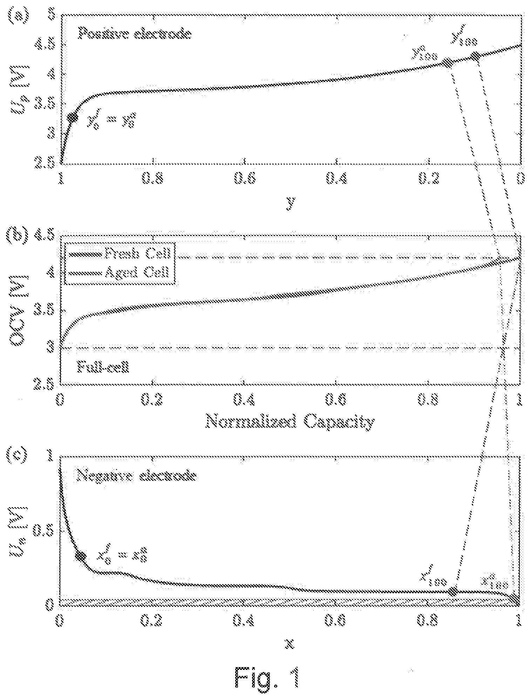

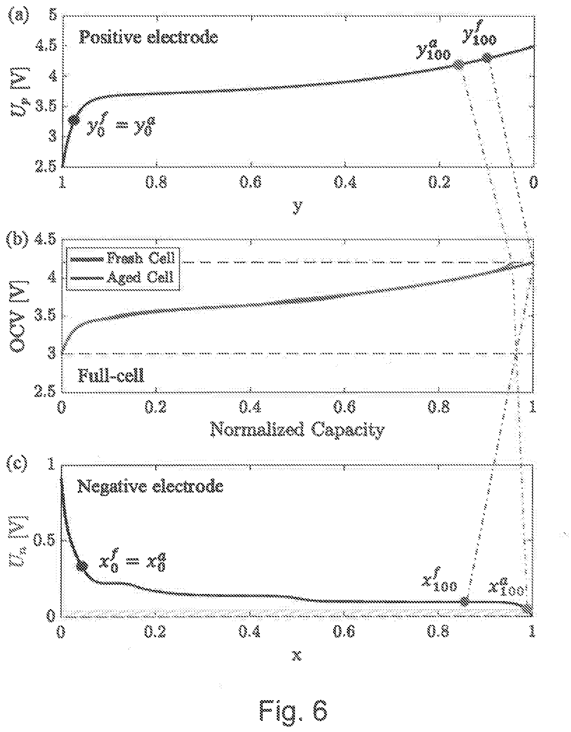

The open circuit voltage (OCV) curves of hypothetical fresh and aged cells are shown in (b) of Fig. 1 and (b) of Fig. 6. In this example, the OCV of the aged cell is simulated with a decrease in the negative electrode capacity by 20% at fully discharged state assuming a loss of active material due to aging. Since the negative electrode is commonly designed to have an excess amount of the capacity in the cell, this particular degradation causes only 5% reduction in the cell capacity operating between the same voltage limits (see (b) of Fig. 1 and (b) of Fig. 6).

The conventional cell-level SOH estimation techniques cannot provide the information on the electrode SOH. To understand what is going on inside the cell, each electrode's half-cell potential curve are plotted in (a) of Fig. 1 and (a) of Fig. 6 ($U_p(y)$ for Nickel-Manganese-Cobalt oxide) and (c) of Fig. 1 and (c) of Fig. 6 ($U_n(x)$ for graphite). The reduction in the negative electrode capacity causes shifts of the utilization range of the electrodes ($[y_0, y_{100}]$ for positive electrode, $[x_0, x_{100}]$ for negative electrode). The utilization range represents the portion of the half-cell potential curve that is utilized when the cell OCV operates between a certain voltage window.

In Figs. (a) and (c) of Fig. 1 and (a) and (c) of Fig. 6, the superscript $f$ is for the fresh cell and $a$ is for the aged cell. In particular, it is observed in (c) of Fig. 1 and (c) of Fig. 6 that the negative electrode utilization $x_{100}$ has shifted to the low potential area marked by red/yellow shades. At near-zero potential, metallic lithium tends to deposit on the graphite surface instead of being intercalated, which accelerates the capacity fade of a cell and could cause an internal short circuit due to the formation of dendrites (Ref 2.5). This example highlights the importance of knowing the electrode SOH beyond the cell level to inform the battery management system (BMS) and potentially protect the cell better.

Several studies on the electrode-level SOH (eSOH) estimation are available in the literature. Early work proposed a model framework that explains the relationship between the cell OCV and individual electrodes for various degradation modes (Ref. 2.6, 2.7). Various approaches have been proposed for the eSOH estimation. Existing approaches can be divided into two groups; voltage fitting and differential analysis.

Voltage fitting approach adopts optimization algorithms to find a parameter set that provides the best fit for the battery voltage curve between the measured data and the model. The authors in Ref. 2.8 parameterized the cell OCV model with the electrode capacity and utilization range and identified these electrode parameters by fitting the cell voltage curve using a genetic algorithm. Birkl *et al.* based the model framework of Ref. 2.7 with the categorized degradation modes (e.g., loss of active material and loss of lithium inventory) and performed degradation diagnostics by fitting the model to measured pseudo-OCV curve (Ref. 2.9, 2.10). In Ref 2.11, an electrochemical model was used for both state of charge (SOC) and SOH estimation, but only the change in the utilization range was considered for aging.

On the other hand, differential analysis has been widely used in electrochemical society focusing on more physical information from the electrode materials. Two most common differential analyses are differential voltage analysis (DVA) (Ref. 2.6, 2.12-2.14) and incremental capacity analysis (ICA) (Ref. 2.15), where those two have an inverse relationship. The basic idea of the differential analysis lies in that the valuable electrochemical information is hidden in raw voltage data. Thus, the voltage data is taken for differentiation by the capacity of the battery (i.e., $dV/dQ$ for DVA; inverse of DVA is ICA $dQ/dV$) to reveal the hidden information of each electrode material. Since electrode materials have their own electrochemical features such as the phase transition of the material during lithium intercalation (Ref. 2.16, 2.17), these distinct features can be used for identifying the contribution of each electrode to the cell.

Both aforementioned approaches share the same assumption that the half-cell potential of each electrode does not change due to aging. Instead, it is assumed that degradation only affects the specific electrode parameters such as the capacity and utilization of the individual electrodes. These parameters scale and shift the utilized half-cell potential on the cell OCV curve, hence, it is normally assumed in estimation that the changes in the OCV curve due to aging can be captured by scaling and shifting the half-cell potentials corresponding to the quantitative changes in the electrode parameters. Thus, the same half-cell potential functions are used for the eSOH estimation throughout the cell life. This assumption on the sole quantitative changes in the electrode parameters is shown to be valid through experiments (Ref. 2.8, 2.10, 2.18). Indeed, no apparent changes in the half-cell potential curves with respect to aging have been observed for Lithium Iron Phosphate (LFP) (Ref. 2.19) and graphite (Ref. 2.19, 2.20). Especially for graphite, it is observed that the peak locations associated with the phase transitions are almost unchanged in the differential voltage $dV/dQ$ curve as the cell ages, not only the potential curve itself (Ref. 2.21).

The first known method is the least-squares based voltage fitting (VF) method used in the battery management system (BMS) community that finds the unknown electrode parameters by minimizing the voltage error between model output and data. This method relies on the invariance of the electrode half-cell potentials as their utilization range shifts and capacity scales. Its reliance on this invariance can be a drawback as electrode potentials of some electrode materials can be distorted as they age.

The second known method among differential analysis techniques is the differential voltage analysis (DVA), widely used in electrochemical society, which relies on the distinct phase transition features in the differential voltage ($dV/dQ$) curve of each electrode. Its reliance on the existence of distinct phase transitions constitutes a drawback of this method as some electrode chemistries do not have such transitions.

What is needed therefore is an improved method and device for estimating the state of health (SOH) of a battery.

LEE SUHAK ET AL: "Beyond Estimating Battery State of Health: Identifiability of Individual Electrode Capacity and Utilization", ANNUAL AMERICAN CONTROL CONE. (ACC), 27 June 2018, pages 2288-2293, proposes individual electrode capacities and utilization windows as parameters related to individual electrode degradation.

BLOOM I ET AL: "Differential voltage analyses of high-power, lithium-ion cells - 1. Technique and application", J. of Power Sources, ELSEVIER vol. 139, no. 1-2, 4 January 2005, pages 295-303, describes techniques and applications for differential voltage analyses of high-power, lithium-ion cells.

US 2017/038436 A1 describes methods for estimating the state of health of a battery.

SUMMARY OF THE INVENTION

The present invention provides a method to accurately estimate the state of health in both the positive and negative electrodes of a battery cell wherein the battery cell may only have one electrode with distinct phase transitions. A SOH estimation method named peak alignment (PA) is disclosed herein which is useful when one of the electrodes may not have distinct features in a $dV/dQ$ curve to be used.

In one aspect, the present disclosure provides an electrical device including a battery cell, a voltage sensor operatively coupled to the battery cell in order to measure a voltage level of the battery cell, a current sensor operatively coupled to the battery cell in order to measure an amount of current drawn from the battery cell, and a battery management system. The battery management system includes a controller in electrical communication with the voltage sensor and the current sensor. The controller is configured to execute a program stored in the controller to receive a plurality of voltage values from the voltage sensor, receive a plurality of current values from the current sensor, wherein each current value is associated with a one of the voltage values, calculate a plurality of total discharge values, wherein each total discharge value is associated with one of the current values, calculate a differential voltage curve using the voltage values and the total discharge values, determine a first differential voltage point and a second differential voltage point on the differential voltage curve, wherein each of the first differential voltage point and the second differential voltage point is at a local peak, and calculate an electrode-level state of health of the battery cell using the first differential voltage point, the second differential voltage point, and a characteristic curve of a fresh reference battery electrode of a reference battery cell, wherein the reference battery cell includes a second reference battery electrode not exhibiting distinct phase transitions during a charge-discharge cycle. Furthermore, the controller may be configured to execute a program stored in the battery management system to identify qualitative shape changes in the half-cell potential curve due to aging and calibrate the aged half-cell potential function through re-fitting the coefficients of the basis functions.

The differential voltage curved calculated using the voltage values and the total discharge values may have local peaks originated from an anode. The differential voltage curve may have local peaks originating from the cathode. The reference battery cell may include a cathode comprised of an active material selected from the group consisting of lithium metal phosphates, lithium metal oxides, or any other combination. The reference battery cell may include a cathode comprised of an active material selected from the group consisting lithium iron phosphates, lithium nickel-manganese-cobalt oxides, or any other combination. The reference battery cell may include an anode comprised of an active material selected from the group consisting graphite, lithium titanate, hard carbon, tin/cobalt alloy, and silicon carbon. The characteristic curve can be a differential voltage curve of the reference battery electrode.

The controller can be configured to execute the program stored in the controller to calculate the state of health of the battery cell based on a utilization range calculated based on a lower bound of a utilization range of an anode of the battery cell. Alternatively or additionally, the controller can be configured to execute the program stored in the controller to calculate the state of health of the battery cell based on an upper bound of a utilization range of an anode of the battery cell. Alternatively or additionally, the controller can be configured to execute the program stored in the controller to calculate the state of health of the battery cell based on an electrode capacity of an anode of the battery cell. Alternatively or additionally, the controller can be configured to execute the program stored in the controller to calculate the state of health of the battery cell based on a lower bound of a utilization range of a cathode of the battery cell. Alternatively or additionally, the controller can be configured to execute the program stored in the controller to calculate the state of health of the battery cell based on an upper bound of a utilization range of a cathode of the battery cell. Alternatively or additionally, the controller can be configured to execute the program stored in the controller to calculate the state of health of the battery cell based on an electrode capacity of a cathode of the battery cell.

In another aspect, the present disclosure provides an electrical device including a battery cell, a temperature sensor operatively coupled to the battery cell in order to measure a temperature of the battery cell, and a battery management system including a controller in electrical communication with the temperature sensor. The controller can be configured to execute a program stored in the controller to determine a state of health of the battery based on a temperature reading from the temperature sensor.

The controller can be configured to execute the program stored in the controller to calculate a negative electrode parameter from the first differential voltage point and the second differential voltage point. Alternatively or additionally, the controller can be configured to execute the program stored in the controller to calculate a utilized positive electrode potential from the negative electrode parameter. Alternatively or additionally, the controller can be configured to execute the program stored in the controller to calculate a positive electrode parameter from the first differential voltage point and the second differential voltage point. Alternatively or additionally, the controller can be configured to execute the program stored in the controller to calculate a utilized negative electrode potential from the positive electrode parameter. Alternatively or additionally, the controller can be configured to execute the program stored in the controller to select the characteristic curve from a plurality of characteristic curves stored in the controller. Alternatively or additionally, the controller can be configured to execute the program stored in the controller to select the second characteristic curve from a plurality of characteristic curves. Alternatively or additionally, the controller can be configured to execute the program stored in the controller to calculate the electrode-level state of health of the battery cell based on first and second characteristic curves of reference battery electrodes of the reference battery cell.

The characteristic curve can be a differential voltage curve of the reference battery electrodes that can contain distinct phase transitions.

The controller can be configured to execute the program stored in the controller to calculate positive electrode parameters from the positive electrode potential. The positive electrode parameters can be calculated using an optimization technique. Alternatively or additionally, the controller can be configured to execute the program stored in the controller to calculate negative electrode parameters from the negative electrode potential. The negative electrode parameter can be calculated using an optimization technique.

In another aspect, the present disclosure provides a method for determining the state of health percentage of a battery cell. The method comprises: measuring voltage in a battery cell; measuring current drawn from a battery cell; and calculating in a controller a state of health of the battery cell based on (i) the voltage measured, (ii) the current measured, (iii) a total discharge calculated based on the current measured, (iv) a differential voltage curve calculated based on the voltage measured and the total discharge calculated, (v) a first differential voltage point and a second differential voltage point, wherein each of the first differential voltage point and the second differential voltage point is at a local peak, (vi) a characteristic curve of a fresh reference battery electrode of a reference battery cell, wherein the reference battery cell includes a second reference battery electrode not exhibiting distinct phase transitions during a charge - discharge cycle.

The differential voltage curve can have local peaks originating from an anode. Alternatively or additionally, the differential voltage curve can have local peaks originating from a cathode. The reference battery cell may include a cathode that comprises an active material selected from the group consisting lithium metal phosphates, lithium metal oxides, or any other combination. Additionally or alternatively, the reference battery cell may include a cathode that comprises an active material selected from the group consisting of lithium iron phosphates, lithium nickel-manganese-cobalt oxides, or any other combination. Alternatively or additionally, the reference battery cell may include an anode that comprises an active material that is selected from the group consisting of graphite, lithium titanate, hard carbon, tin/cobalt alloy, and silicon carbon. The characteristic curve can be a differential voltage curve of the reference battery electrode.

In another aspect, the present disclosure provides a method for determining the state of health percentage of a battery cell. The method includes the steps of measuring a temperature of the battery cell and calculating in the controller the state of health of the battery cell based on the temperature measured.

In another aspect, the present disclosure provides a method in a data processing system. The data processing system comprises at least one processor and at least one memory, wherein the at least one memory comprises instructions executed by the at least one processor to implement a battery state of health estimation system. The method may comprise: (a) receiving a plurality of voltage values from a voltage sensor operatively coupled to a battery cell; (b) receiving a plurality of current values from a current sensor operatively coupled to the battery cell, each current value being associated with one of the voltage values included in the plurality of voltage values; (c) calculating a plurality of total discharge values, each total discharge value being associated with one of the current values included in the plurality of current values; (d) calculating a differential voltage curve based on the voltage values and the total discharge values; (e) determining a first differential voltage point and a second differential voltage point on the differential voltage curve wherein each of the first differential voltage point and second differential voltage point is at a local peak; (f) determining a first set of positive electrode potential values from the differential voltage curve; (g) determining a measure of fit based on the positive electrode potential values; (h) comparing the measure of fit to a predetermined threshold; and (i) estimating a state of health of the battery cell, wherein the state of health of the battery cell is estimated using the first set of positive electrode potential values when the measure of fit is at or below the predetermined threshold, and wherein the state of health of the battery cell is estimated using a second set of positive electrode potential values calculated based on the plurality of total discharge values when the measure of fit is above the predetermined threshold.

Step (e) of the method in may further include finding a match for the first differential voltage point and the second differential voltage point in a cell level and an individual electrode level with a half-cell potential. The method may further include estimating a set of negative electrode parameters using the first differential voltage point and the second differential voltage point.

The second set of positive electrode potential values can be determined based on a half-cell potential value. The half-cell potential value can be obtained from a characteristic curve of a reference battery electrode of a reference battery cell wherein the half-cell potential value is a result of aging. The second set of positive electrode potential values can be more accurate than the first set of positive electrode potential values. The differential voltage curve may include local peaks originating from an anode. Additionally or alternatively, the differential voltage curve may include local peaks originating from the cathode.

We have developed a method for estimation of the state-of-health of each of the two electrodes in a Li-ion battery instead of the traditional lumped state-of-health based on cell capacity. The method uses open-circuit voltage to provide the necessary diagnostics for protecting the battery against aging or failure mechanisms such as lithium plating that lead to shorts and dangerous thermal runaways.

The method for estimation of the state-of-health is successful even for electrode material that does not have distinct phase transitions, such as the widely used commercial Nickel-Manganese-Cobalt (NMC) Li-ion batteries. It is also shown that using the developed method is less sensitive to the exact potential of the cell and provides robust and accurate electrode parameter estimation even when there exists a degradation mechanism such as the transition metal ion dissolution of material that could cause the change of half-cell potential.

It is therefore an advantage of the invention to provide an accurate state of health reading of both electrodes in the case that one electrode in a battery cell may not have distinct phase transitions.

These and other features, aspects, and advantages of the present invention will become better understood upon consideration of the following detailed description, drawings and appended claims.

BRIEF DESCRIPTION OF THE DRAWINGS

Figure 1 shows half-cell open circuit potentials with utilization range shifting: in (a) positive electrode, in (c) negative electrode, and in (b) open-circuit voltage of a fresh (blue) and aged (red) cell.

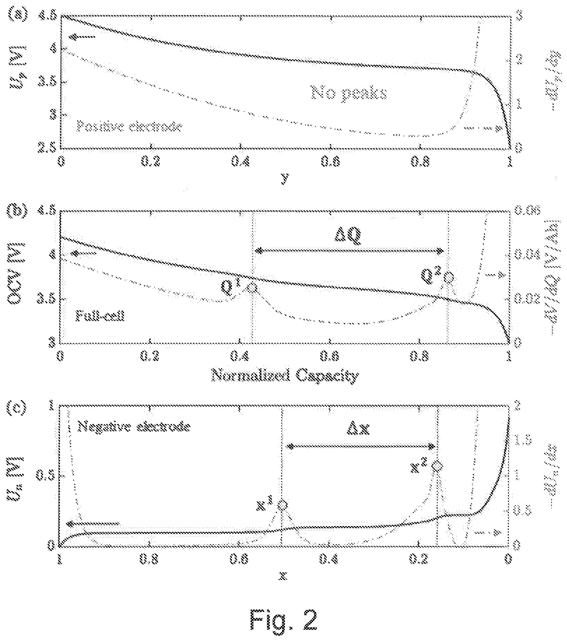

Figure 2 shows voltage and differential voltage curves for the cell containing no peaks in the positive electrode material (e.g., nickel-manganese-cobalt oxide). Peaks are depicted in the differential curves: in (a) positive electrode, in (b) full-cell, and in (c) negative electrode.

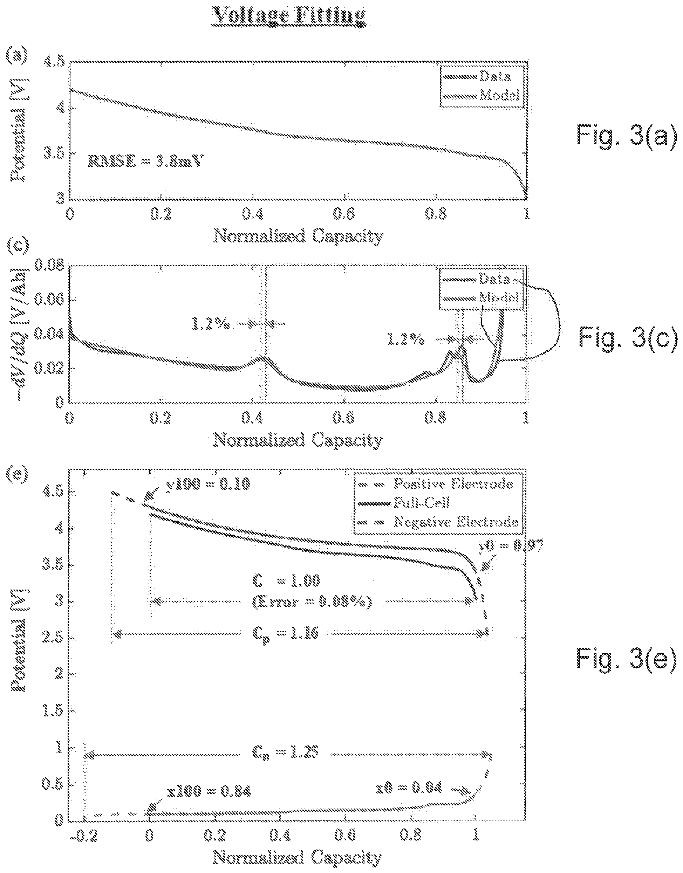

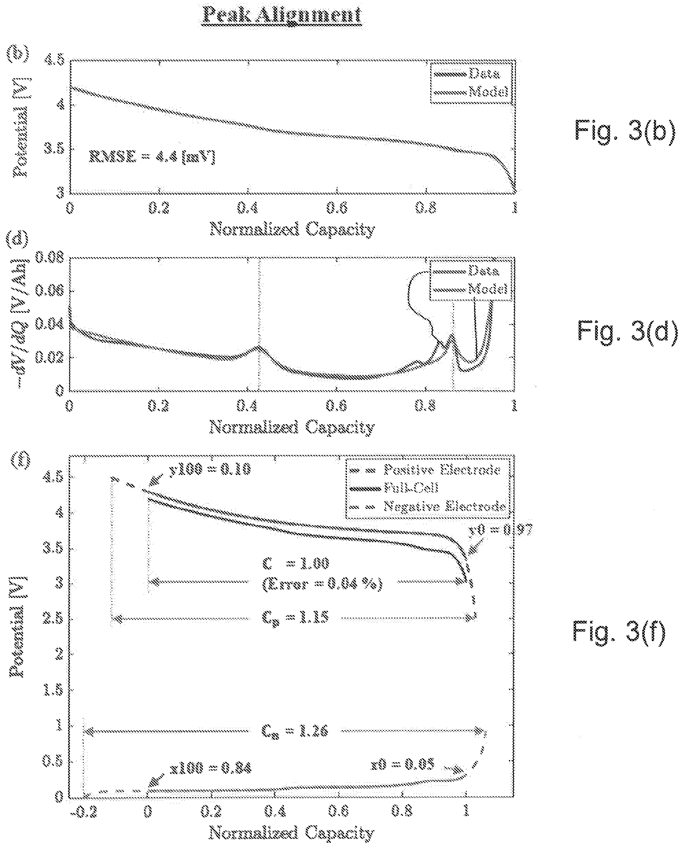

Figures 3(a) to 3(f) show the results of a fresh cell for the voltage fitting (VF) and peak alignment (PA) methods: Fig. 3(a) & Fig. 3(b) show voltage curves, Fig. 3(c) & Fig. 3(d) show differential voltage curves, and Fig. 3(e) & Fig. 3(f) show normalized parameter estimates verifying that the VF and the proposed PA methods work well and match when the cell is fresh.

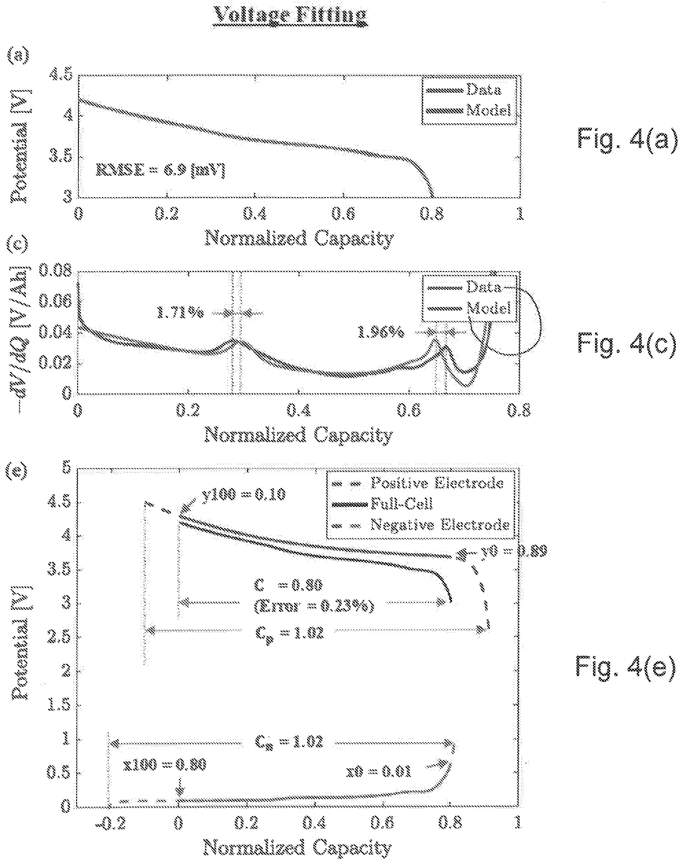

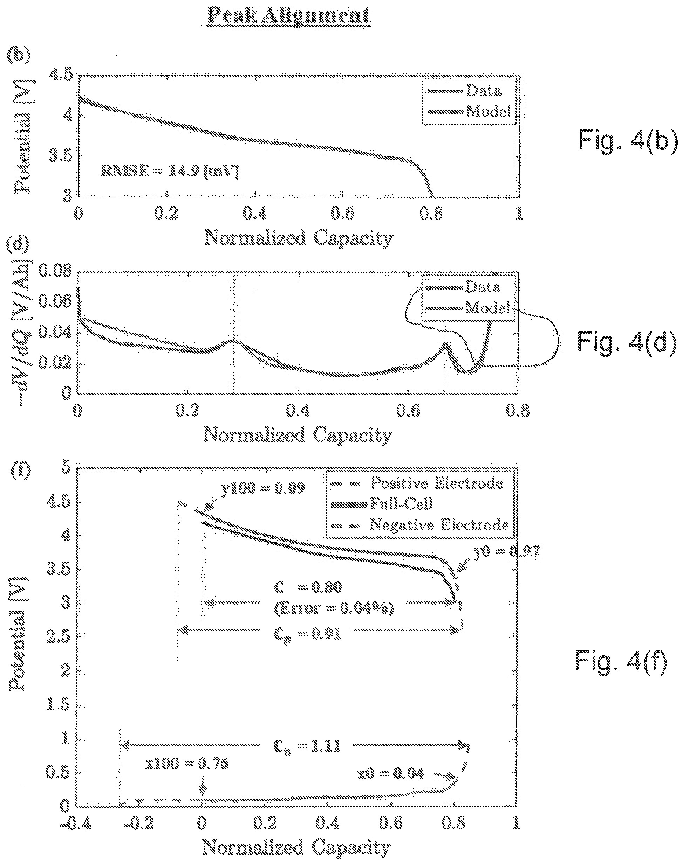

Figures 4(a) to 4(f) show the results of the aged cell room temperature (RT) for the voltage fitting (VF) and peak alignment (PA) methods: Fig. 4(a) & Fig. 4(b) show voltage curves, Fig. 4(c) & Fig. 4(d) show differential voltage curves, and Fig. 4(e) & Fig. 4(f) show normalized parameter estimates showing the difference in the results between the two methods.

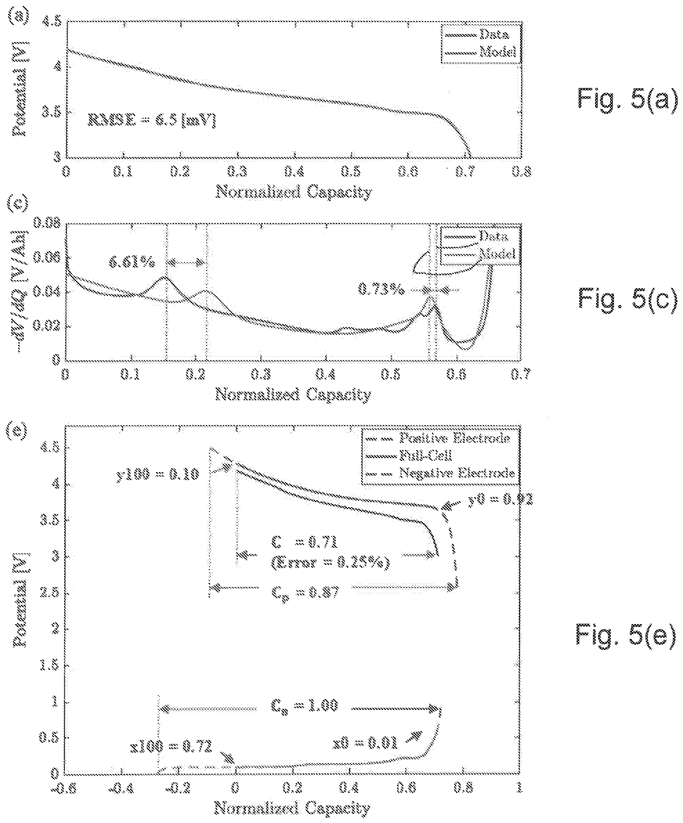

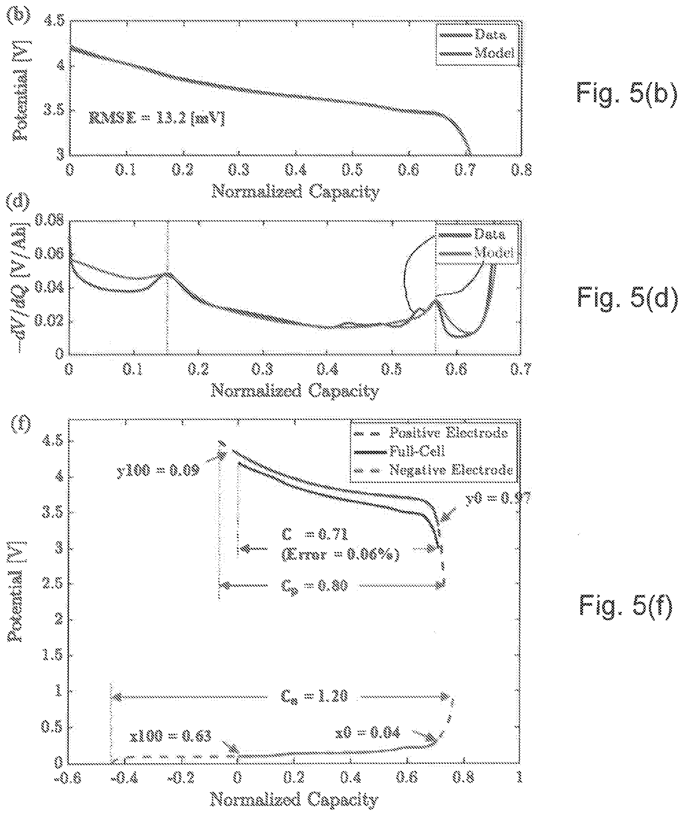

Figures 5(a) to 5(f) show the results of the aged cell high temperature (HT) for the voltage fitting (VF) and peak alignment (PA) methods: Fig. 5(a) & Fig. 5(b) show voltage curves, Fig. 5(c) & Fig. 5(d) show differential voltage curves, and Fig. 5(e) & Fig. 5(f) show normalized parameter estimates showing the difference in the results between the two methods.

Figure 6 shows an example of battery degradation: in (a) half-cell potential of positive electrode with utilization range shifting, in (b) open circuit voltage of fresh and aged cells, and in (c) half-cell potential of negative electrode with utilization range shifting. The shaded area represents near-zero potential where lithium plating is likely to occur.

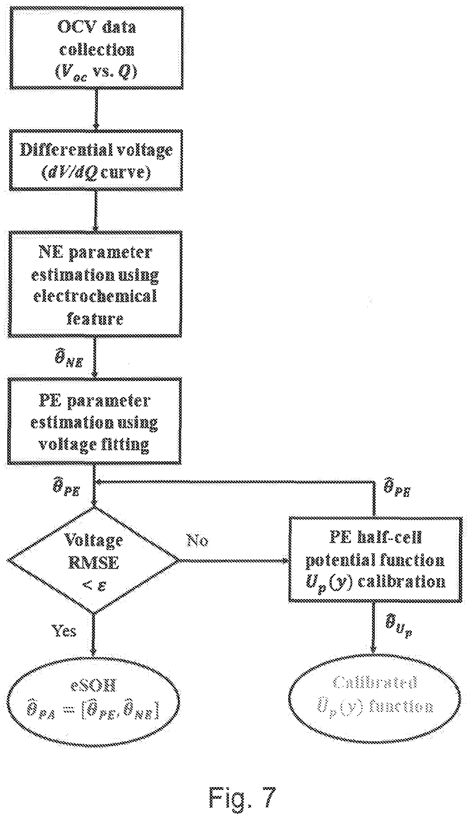

Figure 7 shows a working principle of the proposed peak alignment (PA) method of the present disclosure.

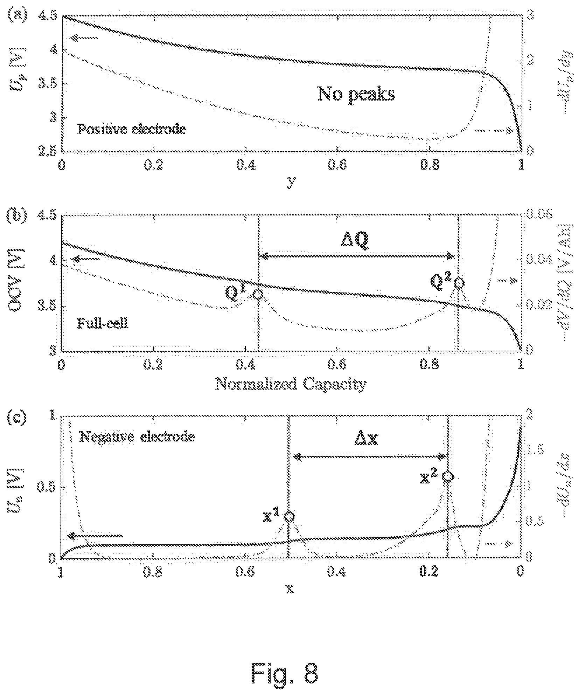

Figure 8 shows schematic voltage and $dV/dQ$ curves for the MNC/graphite cell. Peaks are depicted in the $dV/dQ$ curves: in (a) positive electrode (PE), in (b) full-cell, and in (c) negative electrode (NE).

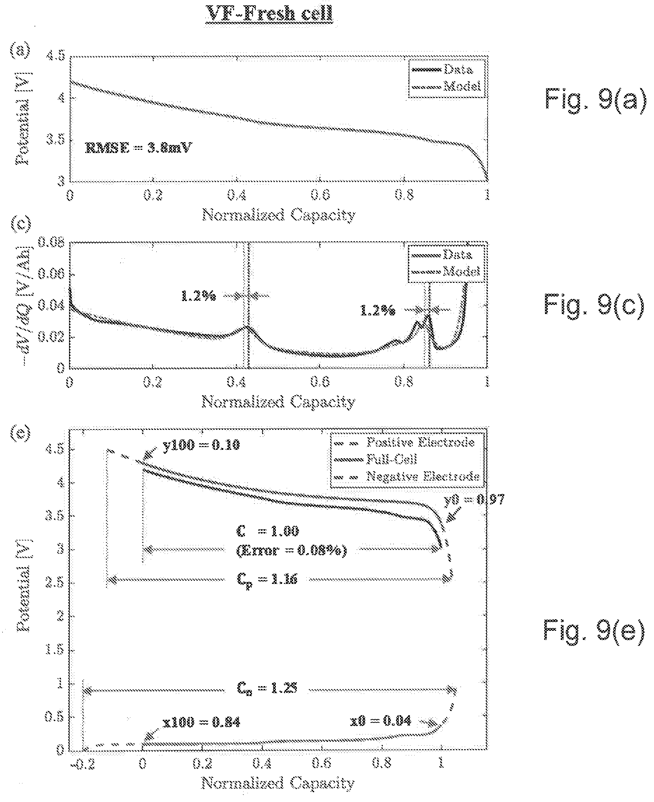

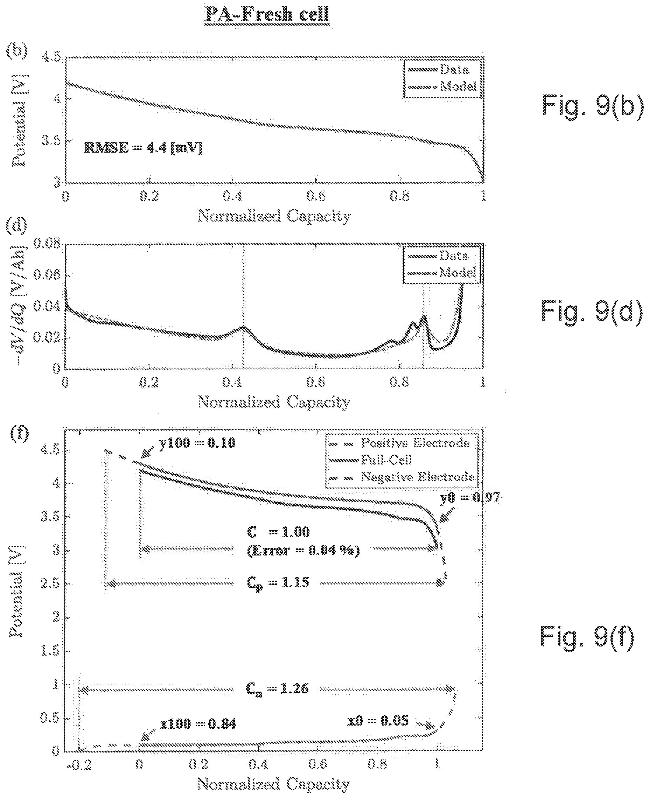

Figures 9(a) to 9(f) show the results of a fresh cell for the conventional voltage fitting (VF) and peak alignment (PA) methods: Fig. 9(a) & Fig. 9(b) show voltage curves, Fig. 9(c) & Fig. 9(d) show differential voltage curves, and Fig. 9(e) & Fig. 9(f) show normalized parameter estimates verifying that the VF and the proposed PA methods work well and match when the cell is fresh.

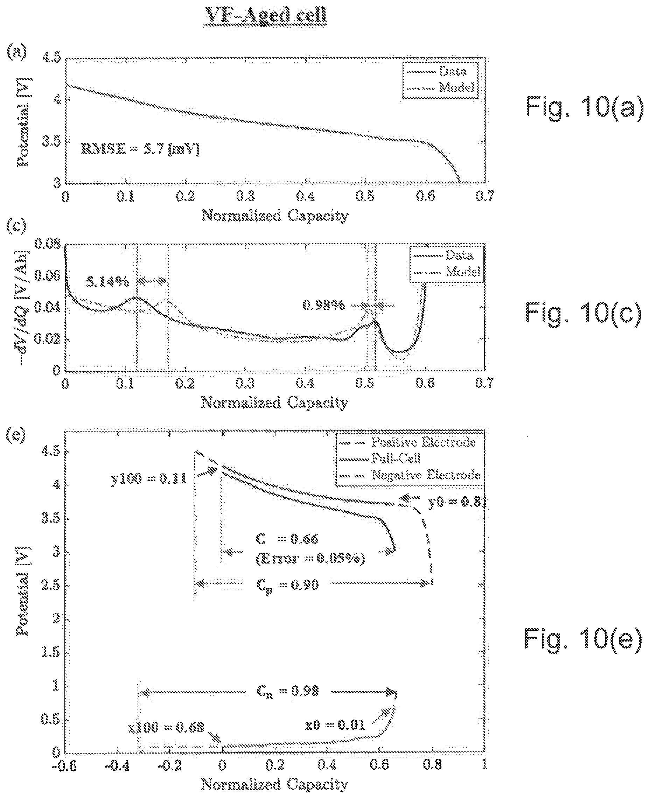

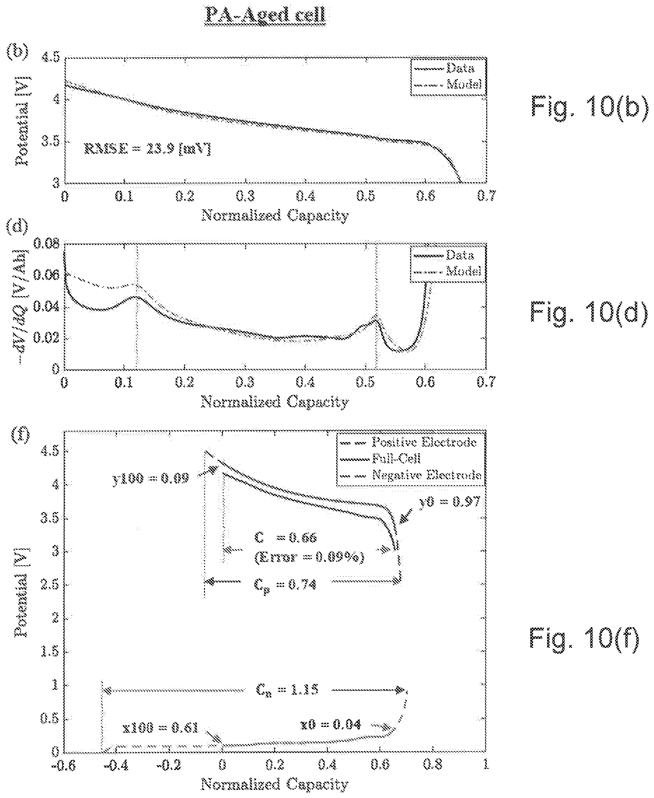

Figures 10(a) to 10(f) show the results of an aged cell for the conventional voltage fitting (VF) and peak alignment (PA) methods: Fig. 10(a) & Fig. 10(b) show voltage curves, Fig. 10(c) & Fig. 10(d) show differential voltage curves, and Fig. 10(e) & Fig. 10(f) show parameter estimates showing a substantial disagreement between the two methods.

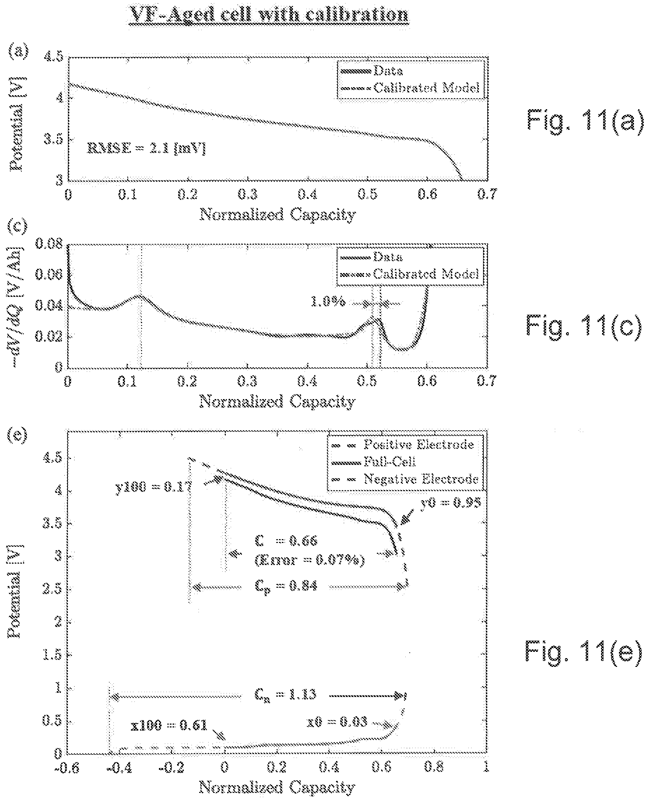

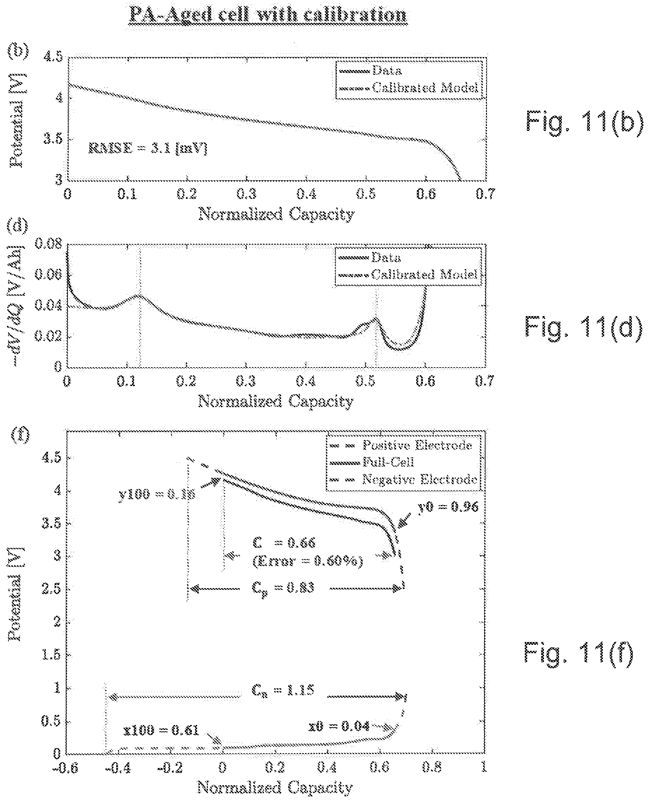

Figures 11(a) to 11(f) show results of the aged cell from the conventional voltage fitting (VF) method and the proposed peak alignment (PA) method after updated the positive electrode potential function $U_p(y)$: Fig. 11(a) & Fig. 11(b) show voltage curves, Fig. 11(c) & Fig. 11(d) show differential voltages, and Fig. 11(e) & Fig. 11(f) show normalized parameter estimates showing the excellent agreement in the results and verifying the proposed method.

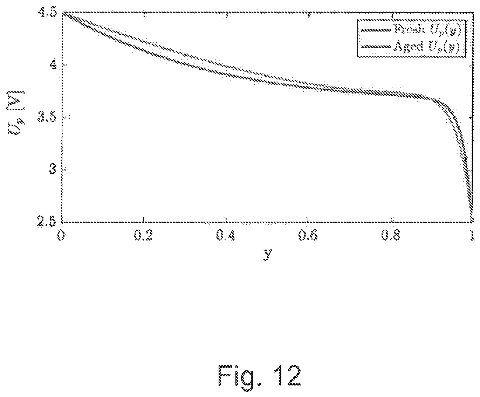

Figure 12 shows a positive electrode half-cell potential change identified from the proposed peak alignment (PA) method with $U_p(y)$ calibration.

## DETAILED DESCRIPTION OF THE INVENTION

The various embodiments described herein provide a method for estimation of the state of health of each of two electrodes in a lithium ion battery. In one embodiment, the method uses open-circuit voltage to provide the necessary diagnostics for protecting the battery against aging or failure mechanisms such as lithium plating that leads to shorts and dangerous thermal runaways. The method enables electrode-specific state of health quantified based on estimating capacity and utilization range of each electrode, which are scaling and sliding factors of electrode half-cell potentials with respect to cell capacity axis.

The method is further compatible with electrode material that does not have distinct phase transitions, such as the widely used commercial nickel-manganese-cobalt (NMC) lithium ion batteries. The method is also less sensitive to the exact potential of the cell and provides robust and accurate electrode parameter estimation even when there exist degradation mechanisms such as the transition metal ion dissolution of material that could cause a change of half-cell potential.

Further embodiments herein provide an algorithm for electrode state of health (eSOH) diagnostics for a lithium ion battery. The eSOH is crucial to understand the detailed degradation status of the battery and prevent dangerous failure within an advanced battery management system (BMS). Electrode diagnostics can be conducted by estimating the electrode specific parameters, such as capacity and utilization range of the electrode.

In another embodiment, a method for electrode state of health estimation is further described herein. The method is developed by relaxing the invariance assumption for the positive electrode's half-cell potential over the course of aging of a battery cell composed of transition metal oxide in the positive electrode. The method not only estimates the electrode parameters but also identifies qualitative shape change in the half-cell potential curve of the electrode due to aging and calibrates the aged half-cell potential function through re-fitting the coefficients of the basis functions.

### EXAMPLES

The following Examples are provided to demonstrate and further illustrate certain embodiments and aspects of the present invention and are not to be construed as limiting the scope of the invention.

### Example 1

#### Overview

Example 1 provides a method to accurately estimate the state of health in both the positive and negative electrodes of a battery cell wherein the battery cell may only have one electrode with distinct phase transitions. A SOH estimation method named peak alignment (PA) is disclosed which is useful when one of the electrodes may not have distinct features in a $dV/dQ$ curve to be used.

The voltage fitting (VF) method is commonly used in the battery management system (BMS) due to its ability to perform well with limited data and be executed recursively in real-time. The VF method relies on the invariance of the electrode open circuit potential (OCP), which can make the accuracy of the electrode SOH estimation of the VF method vulnerable when OCP gets distorted due to aging.

Differential voltage analysis (DVA), which is used offline in the electrochemical society, relies on distinct phase transitions of individual electrodes to link them to the electrode SOH parameters. However, it becomes inapplicable when the electrode materials do not have the distinct phase transitions.

The proposed PA method performs well in the electrode SOH estimation when the OCP has changed and even if one of the electrodes does not show phase transitions. This is experimentally verified by applying the proposed PA method to aged cells with NMC as positive electrode which does not exhibit strong phase transitions thus challenges the DVA, and its OCP changes due to metal ion dissolution at high temperature, hence it challenges the VF method. In the results, a discernible misalignment of the peaks is observed from the VF method indicating incorrect electrode SOH parameter estimation, even though it estimates the cell capacity very accurately. Therefore, it is shown that the precise voltage reconstruction and the accurate cell capacity estimation do not necessarily yield accurate electrode parameter estimation results. In contrast, the proposed PA method succeeds to provide robust and accurate electrode SOH estimation by utilizing the electrochemical features of phase transitions when they exist and combines the information with VF method. A non-limiting example method has been demonstrated to estimate the state of health (SOH) of an NMC cathode and a graphite anode in a lithium-ion battery. Specifically, the electrode SOH estimation is estimating the capacity and the utilization range of both the positive and negative electrodes. The proposed method named peak alignment (PA) overcomes the limitation of prior methods.

In a Li-ion battery, as a cell is charging (backward reaction) the lithium mole fraction or the stoichiometric state x in the negative electrode increases. This increase is balanced with decrease in the lithium mole fraction or stoichiometric state $y$ in the positive electrode. Likewise, as a cell is discharging the forward reaction decreases the stoichiometric state x in the negative electrode while increasing the stoichiometric state $y$ in the positive electrode. The stoichiometric states $x$ and $y \in [0, 1]$ represent the lithium mole fraction for each electrode material. A fully lithiated negative electrode will have $x = 1$. At certain stoichiometric states, an equilibrium potential is defined with respect to lithium metal known as the half-cell open circuit potential (OCP) represented by $U_p(y)$ for a positive electrode and $U_n(x)$ for a negative electrode. When no current is drawn from a cell and the lithium concentrations in each electrode are at equilibrium, the terminal voltage of a cell is equal to the OCV which is the electrical potential difference between the OCP of positive $U_p(y)$ and negative $U_n(x)$ electrode,

$$V_{oc}(z) = U_p(y) - U_n(x) \qquad (1.1)$$

where $z$ is the depth of discharge (DOD) of the cell. Since each electrode does not utilize its full capacity when operating between specified cell voltage limits $V_{max}$ and $V_{min}$, the term utilization range is used for individual electrodes to represent the stoichiometric range actually used. Hence, the utilization range of each electrode can be represented with the range of $[x_0, x_{100}]$ for the negative electrode and $[y_0, y_{100}]$ for the positive electrode, respectively. At the upper and lower voltage limits the following is true,

$$V_{max} = U_p(y_{100}) - U_n(x_{100}) \qquad (1.2)$$

$$V_{min} = U_p(y_0) - U_n(x_0) \qquad (1.3)$$

where parameters $(x_0, y_0)$ correspond to the lower voltage limit and parameters $(x_{100}, y_{100})$ are associated with the upper voltage limit. Parameters $(x_0, y_0)$ are also known as the lower bounds of the utilization range of the negative electrode and positive electrode respectively. Parameters $(x_{100}, y_{100})$ are also known as the upper bounds of the utilization range of the negative electrode and positive electrode respectively. It should be noted that a complete discharge of the battery is not expected in practice, whereas the upper stoichiometric state $(x_{100}, y_{100})$ can be expected to be reached at fully charged state during typical charging protocol. The stoichiometric states of each electrode $(x, y)$ satisfy the following relationship for the cell discharging,

$$z = \frac{Q}{C} = \frac{y - y_{100}}{y_o - y_{100}} = \frac{x_{100} - x}{x_{100} - x_0} \qquad (1.4)$$

where $Q$ is the Amp-hours from the fully charged state and $C$ denotes the total capacity of the cell defined by the upper and lower voltage limits. Then, the following equality holds for the cell capacity with respect to the capacities of individual electrodes,

$$C = C_p(y_0 - y_{100}) = C_n(x_{100} - x_0) \qquad (1.5)$$

where $C_p$, $C_n$ are the capacities of positive and negative electrodes. Combined with Eq. (1.4) and Eq. (1.5), the stoichiometric states can be written as a function of the Amp-hours $Q$ as follows,

$$y = y_{100} + \frac{Q}{C_p}, x = x_{100} - \frac{Q}{C_n} \qquad (1.6)$$

Finally Eq. (1.1) can be written as a function of the Amp-hours $Q$ with the individual electrode parameters = [$C_p$, $C_n$, $y_{100}$, $x_{100}$],

$$V_{oc}(Q) = U_p\left(y_{100} + \frac{Q}{C_p}\right) - U_n\left(x_{100} - \frac{Q}{C_n}\right) \qquad (1.7)$$

Electrode state of health (eSOH) estimation is made by estimating the electrode parameters as the battery ages. Parameters to be estimated are the capacity and the utilization range of individual electrodes, $\theta = [C_p, C_n, y_{100}, x_{100}]$, which scale and slide the utilized half-cell potential of each electrode on the capacity axis. All methods assume the changes in the OCV curve due to aging can be captured by a scaling and/or a shift in the stoichiometric range which are equivalent to the quantitative changes in the capacity and utilization range of electrode materials, not the qualitative shape change in the half-cell OCP curves. Therefore, the same half-cell OCP models are used, which are characterized by half-coin cell made from the fresh cell's electrode material, for the electrode parameter estimation throughout its life. This assumption holds in most cases. Indeed, no apparent changes in the half-cell OCP curves are observed for lithium iron phosphate (LFP) (Ref. 1.11) and graphite (Ref. 1.11, 1.12) due to aging. Moreover, it is shown that the assumption is valid by applying the VF method and the DVA for these chemistry cells (Ref. 1.4, 1.13). It is worth pointing out that the cell total capacity $C$ can also be estimated and will provide a verification of the electrode parameter estimation methods by incorporating the lower voltage limit constraint Eq. (1.3) for the discharge Amp hours Q after the electrode parameters are estimated and substituted into Eq. (1.6),

$$V_{min} = U_p\left(y_{100} + \frac{C}{C_p}\right) - U_n\left(x_{100} - \frac{C}{C_p}\right) \qquad (1.8)$$

Least-Squares Voltage Fitting

The least-squares based voltage fitting (VF) method has been widely used for battery parameter estimation and degradation analysis (Ref. 1.4-1.7, 1.14). Its effectiveness in on-board battery management system has been analyzed even with sparse data since field-use and a limited SOC window does not guarantee the richness of data (Ref. 1.6, 1.7). In this method, all electrode parameters, $\theta = [C_p, C_n, y_{100}, x_{100}]$, are estimated to collectively minimize the overall summation of all the squares of the voltage error between the model output and the measured data. The OCV model is a function of the Amp-hours composed of the positive and negative electrode half-cell OCPs with the electrode parameters as shown in Eq. (1.7). The cell total capacity C also can be estimated from the equality constraints for the voltage limit as explained in Eq. (1.8) and used to independently verify the proposed estimation method by comparing with the measured discharge capacity. Due to the nonlinearities in Eq. (1.7) the optimization problem P1.1 is a non-convex problem with respect to the parameters. Local minima could exist and the optimization solution is affected by the initial guess. Therefore, a global solution can be obtained by exploring multiple initial guesses using methods known in the art.

---

**Algorithm 1.1:** Least-Squares Voltage Fitting (VF)

**Data** : Discharge Amp-hours $Q_i$ and cell OCV $V_{oc,i}$
$(Q_i, V_{oc,i})$ for $i = 1, \dots, n$

**Model** : OCV model $\hat{V}_{oc}$ Eq. (1.7)

**Estimate:** Electrode parameters $\theta = [C_p, C_n, y_{100}, x_{100}]$
and cell total capacity $C$

---

**Procedure**

1 **Generate** multiple initial guesses
$\theta_0 = [C_p, C_n, y_{100}, x_{100}]_0$

2 **Find** the electrode parameters $\theta$ by solving the
following optimization problem,

$$\min_\theta \sum_{i=1}^{n} \left\| \hat{V}_{oc}(Q_i; \theta) - V_{oc,i} \right\|^2 . \qquad (P1.1)$$

subject to,

$$V_{max} = U_p(y_{100}) - U_n(x_{100}).$$

3 **Estimate** the cell total capacity $C$ such that
satisfying the voltage limit constraint Eq. (1.8).

4 **Calculate** the utilization range at fully discharged
state $(y_0, x_0)$

$$y_0 = y_{100} + \frac{C}{C_p}, \quad x_0 = x_{100} - \frac{C}{C_n}. \qquad (1.9)$$

---

Differential Voltage Analysis

Electrode materials undergo several phase transitions during lithium intercalation, and their potential shows a staircase curve where the plateaus correspond to the coexistence of two phases, and the step between the plateaus represents the single-phase stage when the phase transition is completed (Ref. 1.15). This rapid voltage changes at the steps appear as peaks in the differential voltage curve ($dV/dQ$ vs. $Q$). Hence, a $dV/dQ$ curve allows the features in the OCV curve to be seen more clearly. The estimation accuracy of the DVA heavily relies on the data quality of the $dV/dQ$ curve, which can be corrupted by the noisy voltage measurement, low C-rate constant current (e.g., C/20) pseudo-OCV data with the signal processing is recommended for test data (Ref. 1.16-1.18). Since the OCV is simply the potential difference between positive and negative electrodes, the contributions from two electrodes add linearly in the differential voltage (Ref. 1.16). Therefore, each electrode's parameters can be estimated independently by comparing the $dV/dQ$ curve of the cell with the differential voltage of single electrode half-cells separately i.e., $dU_p/dy$, $dU_n/dx$. The capacities of positive and negative materials $C_p$ and $C_n$ are extracted from the accumulated Amp-hours between two peaks, and the utilization range $[x_0, x_{100}]$ and $[y_0, y_{100}]$ are obtained by matching the peak location with respect to the Amp-hours from the single electrode half-cell to the full-cell. A good experimental study can be found in Ref. 1.17. One drawback of the DVA is that it cannot be applied to a cell containing the electrode materials that do not have distinct peaks to be used, as it is the case for NMC positive electrode shown in Fig. 2.

---

**Algorithm 1.2:** Differential Voltage Analysis (DVA)

**Data** : Discharge Amp-hours $Q_i$ and cell OCV $V_{oc,i}$
$(Q_i, V_{oc,i})$ for $i = 1, ..., n$

**Model** : OCP models $\hat{U}_p(y), \hat{U}_n(x)$ and their
differential voltage $d\hat{U}_p/dy, d\hat{U}_n/dx$

**Estimate:** Electrode parameters $\theta_p = [C_p, y_{100}]$,
$\theta_n = [C_n, x_{100}]$, and cell total capacity $C$

---

**Procedure**

1    **Preprocess** pseudo-OCV data e.g., interpolation and filtering

2    **Take** derivative of voltage by difference,

$$\frac{dV}{dQ} = \frac{\Delta V_{oc}}{\Delta Q}. \qquad (1.10)$$

3    **Locate** the distinct peak positions $Q^j$ from the cell $dV/dQ$ curve where $j$ is the peak number.

4    **Locate** the distinct peak positions $y^k, x^l$ from the electrode differential voltage $d\hat{U}_p/dy, d\hat{U}_n/dx$ curves where $k, l$ are the peak numbers.

5    **Match** the pair of peaks $Q^j$ from the cell with the corresponding peaks $y^k, x^l$ from the individual electrode such as,

$$(Q^1, y^1), (Q^2, x^1), (Q^3, y^2), (Q^4, x^2).$$

6    **Estimate** the electrode parameters as follows,

$$C_p = \frac{|Q^1 - Q^3|}{|y^1 - y^2|}, \quad y_{100} = y^1 - \frac{Q^1}{C_p}, \qquad (1.11)$$

$$C_n = \frac{|Q^2 - Q^4|}{|x^1 - x^2|}, \quad x_{100} = x^1 + \frac{Q^2}{C_n}. \qquad (1.12)$$

7    **Estimate** the cell total capacity $C$ such that satisfying the voltage limit constraint Eq. (1.8).

8    **Calculate** the utilization range at fully discharged state $(y_0, x_0)$ Eq. (1.9).

---

Differential Peak Alignment

The PA algorithm of the invention presented here is formulated in a way to utilize the differential voltage of graphite negative electrode $dU_n = dx$, which has several peaks in the differential voltage curve. The key contribution of this method is that it allows the positive electrode parameter estimation to be successful even when the positive electrode does not have peaks to be used, which is common for many positive electrode materials, e.g., nickel-manganese-cobalt (NMC) oxide or lithium iron phosphate (LFP). As shown in (a) in Fig. 2 and Ref. 1.16, NMC material does not show distinct peaks. In this case, the peaks in $dV/dQ$ curve ((b) in Fig. 2) are originated from only the negative electrode ((c) in Fig. 2), which enables estimation of the negative electrode parameter directly using Eq. (1.13). Positive electrode parameters are estimated by the least-squares based voltage fitting for the recovered positive half-cell utilized potential $\tilde{U}_p(Q)$ using Eq. (1.14) after the reconstructed aged negative electrode is accounted for in the cell OCV.

Alternatively, in a battery cell that has a positive electrode that exhibits distinct phase transitions and a negative electrode that does not exhibit distinct phase transitions, the peaks $Q^j$ would be matched with corresponding peaks $[y^1, y^2]$. Additionally, Eq. (1.13) and Eq. (1.14) would be replaced by Eq. (1.15) and Eq. (1.16) respectively. P1.2 would substitute in the negative electrode potential recovered in Eq. (1.16) for the positive electrode potential and use a negative electrode OCP model instead of a positive electrode OCP model in order to find the negative electrode parameters.

$$C_p = \frac{|Q^1 - Q^2|}{|y^1 - y^2|}, y_{100} = y_{100} = y^1 - \frac{Q^1}{c_p} \qquad (1.15)$$

$$\tilde{U}_n(Q) = \widehat{U}_p\left(y_{100} + \frac{Q}{c_p}\right) - \widehat{V}_{oc}(Q) \qquad (1.16)$$

| Algorithm 1.3: Differential Voltage Peak Alignment (PA) | |
|---|---|
| **Data** | : Discharge Amp-hours $Q_i$ and cell OCV $V_{oc,i}$ $(Q_i, V_{oc,i})$ for $i = 1, ..., n$ |
| **Model** | : OCP models $\hat{U}_p(y), \hat{U}_n(x)$ and their differential voltage $d\hat{U}_p/dy, d\hat{U}_n/dx$ |
| **Estimate:** | Electrode parameters $\theta_p = [C_p, y_{100}]$, $\theta_n = [C_n, x_{100}]$, and cell total capacity $C$ |

| **Procedure** | |
|---|---|
| 1 | Preprocess pseudo-OCV data e.g., interpolation and filtering |
| 2 | Take derivative of voltage by difference (Eq. (1.10)). |
| 3 | Locate the distinct peak positions $Q^j$ from the cell $dV/dQ$ curve where $j$ is the peak number. |
| 4 | Locate the distinct peak positions $x^k$ from the negative electrode differential voltage $d\hat{U}_n/dx$ curve where $k$ is the peak number. |
| 5 | Match the pair of peaks $Q^j$ from the cell with the corresponding peaks $x^k$ from the negative electrode (refer to Fig. 2), $$(Q^1, x^1), (Q^2, x^2).$$ |
| 6 | Estimate the negative electrode parameters, $$C_n = \frac{|Q^1 - Q^2|}{|x^1 - x^2|}, \quad x_{100} = x^1 + \frac{Q^1}{C_n}. \qquad (1.13)$$ |
| 7 | Recover the positive electrode potential $\tilde{U}_p(Q)$, $$\tilde{U}_p(Q) = \hat{V}_{oc}(Q) + \hat{U}_n\left(x_{100} - \frac{Q}{C_n}\right). \qquad (1.14)$$ |
| 8 | Generate multiple initial guesses $\theta_{p,0} = [C_p, y_{100}]_0$ |
| 9 | Find the positive electrode parameters $\theta_p$ by solving the following optimization problem, $$\min_{\theta_p} \sum_{i=1}^{n} \left\| \hat{U}_p(Q_i; \theta_p) - \tilde{U}_{p,i} \right\|^2. \qquad (P1.2)$$ |
| 10 | Estimate the cell total capacity $C$ such that satisfying the voltage limit constraint Eq. (1.8). |
| 11 | Calculate the utilization range at fully discharged state $(y_0, x_0)$ Eq. (1.9). |

The parameter estimation results of fresh and aged cells are presented. The results are compared for two methods: (i) voltage fitting (VF), and (ii) peak alignment (PA) according to the present disclosure, since the selected positive electrode material does not have the peaks. The validity of the parameter estimation is checked by the alignment of the peaks in the $dV/dQ$ curve, since the alignment of the peak locations implies correct estimation of the utilization of individual electrodes in the cell.

Test Cell and Aging Condition

TABLE 1.1

TEST CELLS AND AGING CONDITION

|  | Fresh Cell | Aged Cell RT | Aged Cell HT |
| --- | --- | --- | --- |
| Cell SOH | 100% | 80% | 71% |
| Aging Temp. | - | 25°C | 55°C |
| Aging Current | - | 0.5C/1C | 0.5C/1.5C |
| SOC Swing | - | 100%-10% | 95%-15% |

Samsung SDI's prismatic type cells were used for the electrode SOH estimation. The cell chemistry is nickel-manganese-cobalt (NMC) oxide for the positive electrode and graphite for the negative electrode. The single electrode OCP models were characterized from the half-coin cells made from the same materials used in the full-cell. The characterized graphite OCP model was able to capture the two most apparent peaks in $dU_n/dx$ curve as shown in (c) of Fig. 2. In this study, the C/20 discharge data operating the voltage limits between 4.2V and 3.0V at 25°C was used as the pseudo-OCV data for analysis.

To see the trend of the parameter estimation results, two different aged cells were selected. The aging test condition is summarized in Table 1.2. The SOH of the cell is defined by the ratio of the C/20 discharge capacity of the aged cell to that of the fresh cell; for example, the aged cell RT shows 80% SOH ($C_{aged,RT} = 0.80 C_{fresh}$ where $C_{aged}$ are the measured C/20 discharge capacity). Aged cell RT means the aging temperature was at room temperature. Similarly, aged cell HT were cycled under the elevated temperature. Aging current denotes the C-rate for charging/discharging cycle along with the specified state-of-charge (SOC) swing.

Results

The estimation results of one fresh and two aged cells are presented in Figs. 3(a) to 3(f), Figs. 4(a) to 4(f), and Figs. 5(a) to 5(f) for the discharge operation. In each of the figures, the results obtained from the VF method are presented on the left side and the results from the PA method of the present disclosure are on the right side. At each row, the voltage curves of the measured data and reconstructed model output are plotted on the top, the $dV/dQ$ curves are plotted in the middle, and lastly, the utilized potentials of individual electrodes along with the estimated parameters are displayed in the bottom. The estimated cell capacity $C$ is compared to the measured C/20 discharge capacity and its error is also stated. It is noted that the estimated parameters are normalized by the measured C/20 discharge capacity of the fresh cell $C_{fresh}$.

(1) Fresh Cell: The result of the fresh cell is presented in Figs. 3(a) to 3(f). First, the voltage curves of the measured data and the model output are shown in Fig. 3(a) and Fig. 3(b) along with the root-mean-squared error (RMSE) for the voltage. For the fresh cell case, the measured data and the model output show a good agreement as the RMSE value is below 5 mV for both methods. The validity of the parameter estimation is examined by checking the alignment of the peaks in $dV/dQ$ curves shown in Fig. 3(c) and Fig. 3(d), since the alignment of the peaks indicates the accurate estimation on the utilization of the individual electrodes in the full-cell. As can be seen in Fig. 3(c), the VF method does not guarantee the perfect alignment of the peaks. For this reason, the parameter estimates obtained from the two methods are slightly different but within an acceptable range as shown in Fig. 3(e) and Fig. 3(f). Here, the utilized half-cell potentials of the positive and negative electrodes are decoupled. The dashed line of each electrode potential represents the full utilization and the solid line denotes the actual utilization range illustrated by $[y_{100}, y_0]$, $[x_{100}, x_0]$. More specifically, the capacity associated with the full utilization range is represented by the capacity of the positive $C_p$ and negative $C_n$ electrodes, respectively. The estimated cell total capacities $C$ are also displayed with the estimation error.

(2) Aged Cell RT: The result of applying the VF and the proposed PA methods of the present disclosure on the aged cell RT is summarized in Figs. 4(a) to 4(f). Again the DVA technique could not be used because NMC at the positive electrode does not have the distinct phase transitions. Aged cell RT was cycle aged under the room temperature with moderate C-rate until the capacity reached to 80% of the fresh cell capacity. In the voltage curves, both the RMSE values from two methods have increased compared to the fresh cell case as shown in Fig. 4(a) and Fig. 4(b). One thing to note is the increase of the RMSE is much higher for the PA method of the present disclosure than that of the VF method. Another thing is, likewise in the fresh cell case, the discernible misalignment of the peaks are observed in the VF method in Fig. 4(c), which brings the difference in the parameter estimates in Fig. 4(e) and Fig. 4(f): the model shows smaller Amp-hours between the two peaks, therefore the VF method estimates the $C_n$ less than that of the PA method of the present disclosure. The degree of the misalignment has increased, therefore, the difference of parameter estimates become noticeable. Whereas, both the capacity estimations are very accurate showing the estimation errors less than 0.25%.

(3) Aged Cell HT: The result of aged cell HT is summarized in Figs. 5(a) to 5(f). This cell was aged at the elevated temperature of 55°C and the cell capacity is 71% to the nominal capacity. The RMSE values has increased in both the VF method and the PA method of the present disclosure. Similar to the aged cell RT case, the RMSE of the PA method is much higher than that of the fresh cell, but the VF method still shows a good agreement between the model output and data with the RMSE value of voltage less than 7 mV. However, the VF method shows a substantial misalignment of the peaks in the $dV/dQ$ curves in Fig. 5(c) maximum of 6.61% to the normalized cell capacity, even though the cell capacity estimation is very accurate such that the error is less than 0.25%. Recall the fact that the alignment of peaks implies the estimation accuracy of the individual-electrode utilization in the full-cell, the misalignment from the VF method indicates the incorrect electrode parameter estimates. Hence, the lower RMSE and the precise cell capacity estimation result in the conventional VF method do not always provide accurate electrode SOH parameter estimation for the NMC/graphite cell aged under the high temperature. On the contrary, in the PA method of the present disclosure, since the peaks in the full-cell were matched to the phase transitions of the graphite negative electrode, the negative electrode parameter estimation can be used to reliably estimate the positive electrode parameters than the one obtained from the VF method. Lastly, in the bottom row, the normalized parameter estimates and the resulting utilized electrode potentials are presented in Fig. 5(e) and Fig. 5(f).

Discussion

One limitation of the conventional least-squares based voltage fitting (VF) method is that it does not necessarily guarantee the alignment of the peaks in the $dV/dQ$ curve. This is because the peaks, which are discernible only in the differential voltage, are not explicitly considered in the least-squares formulation. Instead, the solution of optimization problem (P1.1) is obtained by minimizing the overall sum of squared errors of voltage between the model and data, which only tells quantitative changes in the capacity and utilization range of each electrode. Therefore, even if there is a change of OCP curve, the VF method always finds the best combination of the electrode parameters that returns the minimum RMSE result. Meanwhile, since the PA method of the present disclosure explicitly uses the peak information to estimate the electrode parameters, it is more robust and reliable on electrode SOH estimation. Regarding the change of OCP curve of the electrode material, metal ion dissolution is well-studied degradation mechanism for the cell containing the transition metal oxide (e.g., Ni, Mn, Co) as a positive electrode. The capacity fade of a cell containing $LiMn_2O_4$ has been attributed to several mechanisms, but manganese dissolution is generally thought to be the most important factor causing the capacity fade (Ref. 1.19). Likewise, long-term cycling degradation of the cell composed of NMC can accelerate due to the increased dissolution of the active material into the electrolyte at the high charge state (Ref. 1.20). More importantly, it is found that the dissolution can be accelerated at elevated temperature (Ref. 1.19, 1.21-1.23). Here, the aged cell HT were cycle aged at high temperature of 55°C until it reached to 71% of its original C/20 capacity. Under this aging condition, the dissolution of the transition metals in the NMC positive electrode is highly expected. This proposition is experimentally verified by the parameter estimation results for the peak alignment method. In Table 1.2 below, the largest deviation of the electrode parameters between the fresh and aged cells is the decrease of the positive electrode capacity $C_p$ contributing the cell capacity fade. This is most likely the result of the loss of positive electrode active material due to the dissolution of the transition metal. If there exists a change of the composition ratio of the consisting transition metals in the positive electrode, the crystal structure of electrode material could change (Ref. 1.24) which can bring the changes in the shape of corresponding OCP $U_p(y)$ consequently. One indication for the change of the positive electrode OCP is the substantial increase of the RMSE for the PA method of the present disclosure, even with the alignment of the peaks. Recall the PA algorithm, after identifying the utilized graphite negative electrode, the positive electrode parameters are estimated by minimizing the error between the recovered potential of positive electrode $\tilde{U}_p$ and the half-cell OCP model $\hat{U}_p$. Therefore, the increase of RMSE is attributed to the mismatch for the positive electrode potential, which can be caused by the change of the OCP curve due to aging.

TABLE 1.2

**SUMMARY OF THE PARAMETER ESTIMATES AND DEVIATIONS FOR THE FRESH AND AGED CELLS USING TWO METHODS**

| Parameter Estimates | Fresh Cell | | Aged Cell RT | | Aged Cell HT | |
|---|---|---|---|---|---|---|
| | Voltage Fitting | Peak Alignment | Voltage Fitting | Peak Alignment | Voltape Fitting | Peak Alignment |
| $C_p$ | 1.16 | 1.15 | 1.02 (-12%) | 0.91 (-21%) | 0.87 (-25%) | 0.80 (-30%) |
| $[y_0, y_{100}]$ | [0.97, 0.10] | [0.97, 0.10] | [0.97, 0.09] (-1%, range) | [0.97, 0.10] (0%, range) | [0.92, 0.10] (-5%, range) | [0.97, 0.09] (-1%, range) |
| $C_n$ | 1.25 | 1.26 | 1.02 (-18%) | 1.12 (-11%) | 1.00 (-20%) | 1.20 (-5%) |
| $[x_0, x_{100}]$ | [0.04, 0.84] | [0.05, 0.84] | [0.01, 0.80] (-1%, range) | [0.04, 0.76] (-9%, range) | [0.01, 0.72] (-11%, range) | [0.04, 0.63] (-25%, range) |
| $C$ | 1.00 | 1.00 | 0.80 (-20%) | 0.80 (-20%) | 0.71 (-29%) | 0.71 (-29%) |
| **OCV RMSE** | 3.8mV | 4.4mV | 6.9mV | 14.9mV | 6.5mV | 13.2mV |
| **Peak Match** | aligned | aligned | misaligned | aligned | misaligned | aligned |

Another interesting observation on the decrease of the negative electrode capacity $C_n$ can be found in Table 1.2. The aged cell RT has much more degradation on the negative electrode capacity $C_n$ even though the cell capacity and the positive electrode capacity has less decrease compared to the aged cell HT. It is known for the graphite that it has the expansion and contraction behavior during lithium intercalation. This means the wider utilization range of the graphite has the more expansion and contraction, which can cause the growth of solid-electrolyte interface (SEI) and accelerate the passivation of the graphite active material at the negative electrode. This proposition agrees with the parameter estimation results in Table 1.2. The decrease in the negative electrode capacity $C_n$ shows relatively higher percentage in the aged cell RT that has a wider utilization range for the negative electrode $[x_0, x_{100}]$.

<u>Summary</u>

For the fresh cell case, the traditional voltage fitting (VF) method and the peak alignment (PA) method of the present disclosure showed a good agreement in general. However, in the case of the aged cell RT and aged cell HT, the parameter estimation results disagreed showing the misalignment of the peaks in $dV/dQ$ curves for the VF method. More specifically at the aged cell HT, which was cycled under the high temperature of 55°C, applying the PA method of the present disclosure showed a significant decrease in the capacity of the positive electrode Cp. It is most likely due to the dissolution of the transition metal and resulting in the loss of active material of the positive electrode. Whereas, the VF method attributed the cell capacity fade to the decrease of the capacities of both positive and negative electrodes. Thus, the VF method and the PA method of the present disclosure showed a disagreement by more than 20% in the negative electrode parameters even though both methods estimated the cell total capacity very accurately less than 0.25% error. This disagreement occurs due to the assumption on the invariance of the half-cell OCPs, which can deteriorate the accuracy of electrode parameter estimation when the half-cell OCP has changed. In the VF method, despite the lower RMSE value and the accurate cell capacity estimation, the misalignment of the peaks was observed in the $dV/dQ$ curves indicating incorrect individual-electrode parameter estimation. On the other hand, since the PA method of the present disclosure uses the peaks which are the physical information of the phase transition of graphite negative electrode, the proposed PA method was less sensitive to the exact shape of the OCP curves and was able to provide robust and accurate electrode SOH estimation. This proposition was verified by the alignment of the peaks in the differential voltage curve.

While in this Example 1, the cell chemistry used was nickel-manganese-cobalt (NMC) oxide for the positive electrode and graphite for the negative electrode, it is envisioned that the method of the invention can be used with other cell chemistries such cells having a cathode comprising an active material selected from the group consisting of lithium metal phosphates (e.g., lithium iron phosphate), lithium metal oxides, or any combination thereof and an anode comprising an active material selected from the group consisting of lithium titanate, hard carbon, tin/cobalt alloy, and silicon carbon. The cathode active materials and anode active materials are not limited to these examples. The method is particularly advantageous where one electrode does not exhibit distinct phase transitions during a charge - discharge cycle.

<u>Example 2</u>

Overview

Example 2 provides a method to estimate electrode state of health by estimating specific parameters, such as capacity and utilization range of an electrode. The method utilizes the phase transition of electrode material to separate individual-electrode's contribution to the cell voltage. This separation provides an estimation of the utilized potential of each electrode and enables the parameter estimation more accurate by reducing the number of unknown parameters.

An electrode state-of-health (eSOH) estimation method is proposed based on a hypothesis that the half-cell potential could be deteriorated due to the electrode level degradation mechanisms. The rationale behind the hypothesis is explained by experimental findings from the literature and a comparison of the eSOH estimation results obtained from a conventional voltage fitting approach and the proposed method for a Nickel-Manganese-Cobalt (NMC)/graphite cell that has been aged at the elevated temperature. The proposed method is a refinement of existing approaches by combining their strengths for robust and accurate estimation. Furthermore, the proposed method identifies qualitative shape changes in the half-cell potential curve of the electrode due to aging and calibrates the aged half-cell potential function through re-fitting the coefficients of the basis functions.

Electrode state of health (eSOH) is crucial to understand the detailed degradation status of the battery and prevent a dangerous failure. Several approaches have been proposed for the eSOH estimation based on an assumption on the invariance of the half-cell potential of each electrode in the cell under aging. Studies in the literature have reported that this assumption is valid for various chemistry of cells. In this study of Example 2, a novel eSOH estimation method is proposed based on a hypothesis that the invariance assumption of the half-cell potential might not be valid for some chemistry of cells under certain aging conditions. The rationale behind this hypothesis is explained by comparing the eSOH estimation results obtained from a conventional voltage fitting method and the proposed method for a Nickel-Manganese-Cobalt (NMC)/graphite cell that has been aged at the elevated temperature. The proposed method is a refinement of two existing approaches in that it utilizes an electrochemical feature, the phase transition of electrode material, to separate individual-electrode's contribution to the cell voltage. Furthermore, the proposed method identifies qualitative shape changes in the half-cell potential curve of each electrode due to aging and calibrates the aged half-cell potential function through re-fitting the coefficients of the basis functions. Example 2 is an extension of Example 1 with the addition of detailed algorithms and half-cell potential function calibration.

The OCV Model

This section describes a relationship of the OCV model and the electrode parameters that are related to the state of health of individual electrodes. For a Li-ion battery with lithium metal oxide $LiMO_2$ for the positive electrode (PE) and graphite $C_6$ for the negative electrode (NE), as a cell is charging (backward reaction) stoichiometric state x in the graphite increases. This increase is balanced with a decrease in stoichiometric state y in the metal oxide. Likewise, as a cell is discharging the forward reactions occur at each electrode as following:

$$Li_xC_6 \rightleftharpoons xLi^+ + xe^- + C_6$$

$$Li_yMO_2 + (1\text{-}y)Li^+ + (1\text{-}y)e^- \rightleftharpoons LiMO_2,$$

The stoichiometric states *x* and *y* represent lithium mole fraction of each electrode materials. For example, a fully lithiated graphite is $x = 1$ for $Li_xC_6$, i.e., one lithium atom per six carbon atoms. When a cell is at equilibrium state without current flowing, the terminal voltage of the cell is equal to the OCV which is the electrical potential difference between the half-cell potential of positive $U_p(y)$ and negative $U_n(x)$ electrode,

$$V_{oc}(z) = U_p(y) - U_n(x), \quad (2.1)$$

where *z* is the depth of discharge (DOD) of the cell (i.e., DOD = 1-SOC) and satisfies the following relationship with the stoichiometric state of each electrode *x* and *y* where their range $x \in [x_0, x_{100}] \subset [0,1]$ and $y \in [y_0, y_{100}] \subset [0,1]$,

$$z = \frac{Q}{C} = \frac{y - y_{100}}{y_0 - y_{100}} = \frac{x_{100} - x}{x_{100} - x_0}, \quad (2.2)$$

where *Q* is the discharge Amp-hours from fully charged state found by coulomb counting and *C* denotes the cell capacity defined by the upper $V_{max}$ and lower $V_{min}$ voltage limits that satisfy

$$V_{max} = U_p(y_{100}) - U_n(x_{100}), \qquad (2.3)$$

$$V_{min} = U_p(y_0) - U_n(x_0), \qquad (2.4)$$

where subscripts 100 and 0 indicate the stoichiometric states at both ends of utilization range at upper and lower voltage limits, respectively. The battery manufacturer specifies the voltage limits to prevent the overcharge or over-discharge thus the individual electrodes are not fully utilized. Note that the cell upper voltage limit $V_{max}$ and thus Eq. (2.3) is more often expected in practice using typical constant current constant voltage (CCCV) charging protocol than the lower limit $V_{min}$ when the battery is completely depleted. Then, the following equality holds for the capacities of individual electrodes, $C_p$ for PE and $C_n$ for NE, with respect to the cell capacity $C$

$$C = C_p(y_0 - y_{100}) = C_n(x_{100} - x_0). \qquad (2.5)$$

Combining Eq. (2.2) and Eq. (2.5), the stoichiometric state of each electrode can be written as a function of the discharge Amp-hours $Q$

$$y = y_{100} + \frac{Q}{C_p}, x = x_{100} - \frac{Q}{C_n}. \qquad (2.6)$$

Finally Eq. (2.1) can be written as a function of the discharge Amp-hours $Q$ with the electrode parameters (i.e., electrode capacity and utilization range)

$$\theta = \left[ C_p, C_n, y_{100}, x_{100} \right],$$

$$V_{oc}(Q; \theta) = U_p\left(y_{100} + \frac{Q}{C_p}\right) - U_n\left(x_{100} - \frac{Q}{C_n}\right). \qquad (2.7)$$

Degradation Modes and Diagnostics

For an aging diagnosis, we refer to commonly defined degradation modes: loss of lithium inventory (LLI) for a whole cell and loss of active material (LAM) for each electrode (Ref. 2.7, 2.9). LLI is the most common degradation mode for the cell capacity fade where it represents the irreversible lithium consumption by parasitic reactions, such as surface film formation and lithium plating, and the lithium loss associated with the loss of lithiated active materials. LAM means the active material is no longer available for lithium intercalation, which can occur at each electrode, thus, it is further clustered into LAM$_{PE}$ for positive electrode and LAM$_{NE}$ for negative electrode. LAM$_{PE}$ can be caused by structural disordering, dissolution or loss of electrical contact and LAM$_{NE}$ is due to particle cracking or blocking of active sites by resistive surface layers. These mechanisms can lead to both cell capacity and power fade.

Electrode diagnostics is conducted by quantifying these degradation modes from the identified electrode parameters $\theta = [C_p, C_n, y_{100}, x_{100}]$. The evolution of the estimated electrode capacities $C_p$ and $C_n$ directly indicates the LAM of positive and negative electrode. The LLI can be generally represented by the ratio of total lithium inventory. At any point, total lithium inventory can be defined by the sum of lithium contents in the individual electrode. Since the stoichiometric states $x$ and $y$ are the degree of lithiation of the corresponding active material, the lithium content in one electrode can be calculated by multiplying the stoichiometric state to the capacity of the electrode (e.g., $Li_{PE} = y * C_p$). Therefore, once the electrode parameters are identified, the degradation modes can be quantified as follows:

$$LAM_{PE} = \frac{\Delta C_p}{C_p^f}, \qquad (2.8)$$

$$LAM_{NE} = \frac{\Delta C_n}{C_n^f}, \qquad (2.9)$$

$$LLI = 1 - \frac{y_{100}^{a} C_{p}^{a} + x_{100}^{a} C_{n}^{a}}{y_{100}^{f} C_{p}^{f} + x_{100}^{f} C_{n}^{f}}, \qquad (2.10)$$

where the superscript $f$ represents the estimate from fresh cell and $a$ for the aged cell.

Electrode parameters are estimated regularly as the battery ages to decipher the main degradation mode and to protect the cell from dangerous failures. Under the assumption on the invariance of the half-cell potential of electrode in the cell, the unknown electrode parameters are the capacity and utilization range of the positive and negative electrodes, $\theta = [C_{p}, C_{n}, y_{100}, x_{100}]$. Thus, the parameters are determined by finding the best representation of the battery data (e.g., voltage or $dV/dQ$ curves) by perturbing the electrode parameters. Hence, the OCV model Eq. (2.7) keeps using the same half-cell potential functions for fresh and aged cells in the conventional eSOH estimation approaches. The half-cell potential functions are typically characterized by coin-cell measurements, which is typically made by the fresh cell's electrode material and lithium metal as a reference electrode.

A hypothesis is proposed that some PE materials do not always remain intact for certain aging conditions, based on the experimental studies on the aging of the PE materials in the literature, particularly consisting of transition metals (e.g., Ni, Mn, Co). Note that, as the cell ages, the cell capacity $C$ also becomes an unknown parameter. Since this cell capacity is defined as the total amount of the Amp-hours between the specified voltage windows, it also can be estimated by the proposed method when the electrode parameters are identified and the voltage limits are specified.

Voltage Fitting (VF)

The least-squares based voltage fitting (VF) approach has been widely applied for battery parameter estimation and aging diagnostics (Ref. 2.8, 2.9). This approach's effectiveness in onboard battery management system was analyzed even for a partial data window to ensure its robustness in estimation (Ref. 2.23) because the applications in practice do not guarantee the richness of data measurement. The detailed procedure is presented in algorithm 2.1. In this approach, the electrode parameters are estimated by minimizing the summation of the squares of the voltage error between the model and measured data. The model here is the OCV model composed of two half-cell potential functions as given in Eq. (2.7) where the unknown parameters are the electrode capacity and utilization $\theta = [C_{p}, C_{n}, y_{100}, x_{100}]$, and the cell capacity $C$. The half-cell potential functions $U_{p}(y)$ and $U_{n}(x)$ are given either from experimental measurements on half-coin cells (Ref. 2.16) or from the literature for some popular chemistry (Ref. 2.24-2.27). Voltage data can be measured from a low C-rate constant current (e.g., C/20 rate) as a pseudo-OCV and it can be further processed with filtering and down-sampling using interpolation for computational benefit. Note that the optimization problem $P2.1$ has an equality constraint for the maximum voltage limit, which results in providing additional information for the parameters and improving the estimation accuracy. Since the optimization problem $P2.1$ is a non-convex problem with respect to the parameters, local minima could exist, and the optimization solution is affected by the initial guess. Hence, the global optimum is usually recommended.

---

**Algorithm 2.1:** Voltage Fitting (VF)

---

**Data** : Discharge Amp-hours $Q_i$ and cell OCV $V_{oc,i}$ $(Q_i, V_{oc,i})$ for $i = 1, ..., n$

**Model** : OCV model $V_{oc}$ in Eq. (2.7)

**Estimate:** Electrode parameters $\theta = [C_p, C_n, y_{100}, x_{100}]$ and cell total capacity $C$

---

**Procedure**

1  **Preprocess** OCV data e.g., interpolation and filtering

2  **Generate** multiple initial guesses $\theta_0 = [C_p, C_n, y_{100}, x_{100}]_0$

3  **Find** the electrode parameters $\theta$ by solving the following non-convex optimization problem,

$$\min_{\theta} \sum_{i=1}^{n} \|V_{oc}(Q_i; \theta) - V_{oc,i}\|^2 . \qquad (P2.1)$$

subject to,

$$V_{max} = U_p(y_{100}) - U_n(x_{100}).$$

4  **Estimate** the cell capacity $C$ such that satisfying the lower voltage limit constraint (see Eq. (2.13)).

5  **Estimate** the utilization range at fully discharged state $(y_0, x_0)$,

$$\hat{y}_0 = \hat{y}_{100} + \frac{\hat{C}}{\hat{C}_p}, \quad \hat{x}_0 = \hat{x}_{100} - \frac{\hat{C}}{\hat{C}_n}.$$

---

Peak Alignment (PA)

Electrode materials undergo several phase transitions during lithium intercalation, and their potentials show a staircase curve where plateaus correspond to the coexistence of two phases, and step between the plateaus represents single-phase stage when the phase transition is completed (Ref. 2.16, 2.24). This sharp change at the step appear as a peak in the differential voltage curve ($dV/dQ$ vs. $Q$). Hence, derivative of the voltage allows the electrochemical features to be seen clearly as peaks in the $dV/dQ$ curve. Differential voltage analysis (DVA) uses the $dV/dQ$ curve to identify the electrode parameters (Ref. 2.6). Since the OCV is the potential difference between two electrodes, each electrode potential can be simply separated by subtracting one of the electrode potentials from the cell OCV. Utilization of the individual electrode is identified by comparing the $dV/dQ$ curve of the cell with respect to the electrode's half-cell $dV/dQ$ curve (i.e., $dU_p/dy$, $dU_n/dx$). The electrode capacities, $C_p$ and $C_n$, are scaling factors that extends the half-cell potential curve to the cell capacity axis. The utilization ranges at fully charged state, $y_{100}$ and $x_{100}$, are identified by matching peak locations from the single electrode half-cell to the full-cell.

A novel method named peak alignment (PA) is proposed by leveraging the conventional DVA for separating the electrode's potential from the cell OCV. The algorithm 2.2 presented here is formulated in a way to utilize the graphite anode and its electrochemical feature (i.e., phase transitions). One of the key contributions of this method is that it allows the PE parameter estimation to be successful using voltage fitting even when the PE material does not have distinct peaks to be used for the conventional DVA. As shown in (a) of Fig. 8, since NMC does not have the peaks, the peaks in the cell *dV/dQ* curve in (b) of Fig. 8 are all attributed to the graphite anode in (c) of Fig. 8. Estimation of the NE parameters uses this unique peak information (refer to Eq. (2.11)); scaling from the half-cell potential (Un of NE in this case) to the cell OCV is obtained by a ratio of the Amp-hours distance between two distinct peaks in the cell *dV/dQ* curve to the stoichiometric distance between two corresponding peaks in the NE *dV/dQ* curve. Furthermore, aligning the corresponding peaks (e.g., $Q^1$ and $x^1$) by shifting the scaled half-cell potential provides an estimate of the utilization range $x_{100}$. Identifying the NE parameters allows the separation of the PE potential from the cell OCV by Eq. (2.12), then, the PE parameters are estimated by the least-squares based voltage fitting for the extracted PE potential $\tilde{U}_p(Q)$ as formulated in *P*2.2. Regarding the issue on the absence of the peaks from the electrode material, Honkura *et al.* (Ref. 2.12) and Dahn *et al.* (Ref. 2.13) proposed to use the least-squares fitting on the differential voltage curve, which increase the sensitivity of the cost function change associated with the electrode parameters. However, both assumed the invariance of the half-cell potentials.

---

**Algorithm 2.2: Peak Alignment (PA)**

| | |
|---|---|
| **Data** | : Discharge Amp-hours $Q_i$ and cell OCV $V_{oc,i}$ $(Q_i, V_{oc,i})$ for $i = 1, ..., n$ |
| **Model** | : Half-cell potential functions $U_p(y), U_n(x)$ |
| **Estimate:** | Electrode parameters; PE $\theta_p = [C_p, y_{100}]$, NE $\theta_n = [C_n, x_{100}]$, and cell capacity $C$ |

---

**Procedure**

1. **Preprocess** OCV data and get *dV/dQ* curve
2. **Locate** the distinct peak positions $Q^j$ from the cell *dV/dQ* curve where $j$ is the peak number.
3. **Locate** the distinct peak positions $x^k$ from the NE differential voltage $dU_n/dx$ curve where $k$ is the peak number.
4. **Match** the pair of peaks $Q^j$ from the cell with the corresponding peaks $x^k$ from the NE (see Fig. 8).

$$(Q^1, x^1), (Q^2, x^2).$$

5. **Estimate** the NE parameters,

$$\hat{C}_n = \frac{|Q^1 - Q^2|}{|x^1 - x^2|}, \quad \hat{x}_{100} = x^1 + \frac{Q^1}{\hat{C}_n}. \quad (2.11)$$

6. **Extract** the PE utilized potential $\tilde{U}_p(Q)$,

$$\tilde{U}_p(Q) = V_{oc} + U_n\left(\hat{x}_{100} - \frac{Q}{\hat{C}_n}\right). \quad (2.12)$$

7. **Generate** multiple initial guesses $\theta_{p,0} = [C_p, y_{100}]_0$
8. **Find** the PE parameters $\theta_p$ by solving the following optimization problem,

$$\min_{\theta_p} \sum_{i=1}^{n} \left\| U_p\left(y_{100} + \frac{Q_i}{C_p}\right) - \tilde{U}_p(Q_i) \right\|^2. \quad (P2.2)$$

---

| | |
|---|---|
| 9 | **Calculate** the root mean square error (RMSE) of the PE potential fit in $P2.2$ |
| 10 | **If RMSE** > threshold, then calibrate the PE half-cell potential function $U_p(y)$ by refitting the coefficient of the basis function, |

$$\min_{\theta_p, \theta_{U_p}} \sum_{i=1}^{n} \left\| U_p(Q_i; \theta_p, \theta_{U_p}) - \tilde{U}_p(Q_i) \right\|^2 . \quad (P2.3)$$

subject to,

$$U_p(y = 0) = U_{p,max},$$
$$U_p(y = 1) = U_{p,min},$$

where $\theta_{U_p}$ are the coefficients of the PE half-cell potential function $U_p(y)$.

| | |
|---|---|
| 11 | **Estimate** the cell capacity $C$ such that satisfying the lower voltage limit constraint (see Eq. (2.13)). |
| 12 | **Calculate** the utilization range at fully discharged state $(y_0, x_0)$, |

$$\hat{y}_0 = \hat{y}_{100} + \frac{\hat{C}}{\hat{C}_p}, \quad \hat{x}_0 = \hat{x}_{100} - \frac{\hat{C}}{\hat{C}_n}.$$

Peak Alignment with Half-Cell Potential Calibration

Degradation of the battery can result in two different ways in terms of the battery parameter change. One is quantitative changes in the electrode parameters, e.g., electrode capacity and utilization range $\theta = [C_p, C_n, y_{100}, x_{100}]$, that the conventional eSOH estimation methods provide. These quantitative changes are related to the degradation modes of the cell: LLI and LAM as explained in Section II-B. The other way is qualitative changes in the electrode material structure that could affect its electrochemical properties including potential change. In electrochemical society, aging effect of various electrode materials has been extensively studied through experiments (Ref. 2.19, 2.20, 2.28, 2.29). First of all, transition metal (TM) dissolution is a well-studied degradation mechanism for cathode materials (Ref. 2.30). Moreover, as a cell composed of NMC cathode degrades to its end-of-life (EOL) from a long-term cycling, degradation is accelerated due to the increased dissolution of the active material into the electrolyte at the high charge state (Ref. 2.31). More importantly, it is found that the TM dissolution is accelerated at the elevated temperature (Ref. 2.32-2.34). Another crucial degradation mechanisms for cathode are structural disordering and surface film modification. The authors in (Ref. 2.32) showed a significant lattice expansion for the thermally aged NMC cathode and the SEI film thickness growth indicating the impedance rise of the cell. Therefore, assuming the invariance of the half-cell potentials for eSOH estimation might not be valid for certain circumstances.

If there exists changes in the potential profile of the individual electrode, it would affect the accuracy of the conventional eSOH estimation and become more likely when the aged cell is close to its end of life (EOL). Hence, the proposed method calibrates the half-cell potential function if needed, as well as identifies the electrode parameters. In this study of Example 2, the invariance assumption is relaxed only for the NMC PE, but not for the graphite NE based on studies in the literature on the graphite anode aging (Ref. 2.19, 2.20). Especially, in Ref. 2.21, it is observed that not only the half-cell potential profile, but also the peak locations associated with the phase transitions are almost unchanged in the differential voltage curve of the graphite anode.

The calibration of the PE half-cell potential function is formulated in algorithm 2.2, step 10, where the fitting parameters are now both the PE parameters $\theta_p$ and the coefficients of the half-cell potential basis functions $\theta_{U_p}$. Two additional constraints are considered for $U_p(y)$ at $y = 0$ and $y = 1$ assuming the upper and lower voltage limits of the electrode material do not change at fully lithiated and delithiated states. These constraints help to avoid an over-fitting issue in the optimization problem *P*2.3 due to the increased number of fitting parameters. The basis function of various electrode materials can be found in the literature (Ref. 2.24-2.27). One possible half-cell potential function for the NMC PE is

$$U_p(y) = a_0 + a_1 y + a_2 y^2 + a_3 y^3 + a_4 \exp(a_5 y + a_6),$$

where $\theta_{U_p} = [a_0,...,a_6]$.

Estimation of Cell Capacity

It is worth pointing out that the cell capacity *C* is estimable by incorporating the lower voltage limit $V_{min}$ constraint when the electrode parameters are identified. Once the electrode parameters are estimated (i.e., $\hat{\theta} = [\hat{C}_p, \hat{C}_n, \hat{y}_{100}, \hat{x}_{100}]$), it is possible to find a specific Amp-hours *C* that satisfies the lower voltage limit constraint as shown in Eq. (2.13) by solving an unconstrained optimization problem P2.4 as following,

$$V_{min} = U_p\left(\hat{y}_{100} + \frac{C}{\hat{C}_p}\right) - U_n\left(\hat{x}_{100} - \frac{C}{\hat{C}_p}\right). \quad (2.13)$$

$$\min_C \left\| V_{oc}(C; \hat{\theta}) - V_{min} \right\|^2. \qquad (P2.4)$$

Test Cell and Aging Condition

In this study, Samsung SDI's prismatic Nickel-Manganese- Cobalt (NMC) oxide/graphite cells were used. The C/20 discharge data operating between the voltage limits of 4.2V and 3.0V was measured as the pseudo-OCV data at 25°C. The half-cell potential functions were characterized for each electrode by the coin cell's voltage data at C/20 rate. The graphite half-cell potential function was able to capture the two most apparent peaks in $dU_n/dx$ curve as shown in (c) of Fig. 8. Aging test conditions are summarized in Table 2.1. The aged cell selected here has 66% SOH, which is beyond the typical definition of EOL (i.e., EOL is defined when the cell capacity has decreased by 20% from fresh status). Constant current has been applied to the aged cell as an aging cycle at 0.5C/1.5C C-rate for continuous charge/discharge between 15% and 95% SOC under the high temperature at 45°C. It is noted that there were more similarly aged cells that produce similar results, thus only one aged cell result is presented.

TABLE 2.1

TEST CELLS AND AGING CONDITION

|  | **Fresh Cell** | **Aged Cell** |
| --- | --- | --- |
| **Cell SOH** | 100% | 66% |
| **Aging Temp.** | - | 45°C |
| **Aging Current** | - | 0.5C/1.5C |
| **SOC Swing** | - | 95%-15% |

eSOH Estimation Results

The estimation results of the fresh and aged cells are presented in Figs. 9(a) to 9(f), Figs. 10(a) to 10(f), and Figs. 11(a) to 11(f). In each figure, the results obtained from the conventional VF method are plotted on the left side and the results from the proposed PA method are on the right side. At each row, the voltage curves of the measured data and model output are plotted on the top, the $dV/dQ$ curves are plotted in the middle, and lastly, the utilized potentials of individual electrodes along with the estimated parameters are depicted in the bottom. The estimated cell capacity *C* is compared to the measured C/20 discharge capacity and its error is stated inside the parenthesis. Here all the capacity values are normalized by the C/20 discharge capacity of the fresh cell $C_{fresh}$ for clarity.

(1) Fresh cell: The result of the fresh cell is presented in Figs. 9(a) to 9(f). First, the voltage curves of the measured data and the model output are plotted in Fig. 9(a) and Fig. 9(b) along with the RMSE for the voltage. For the fresh cell case, the data and the model show a very good agreement (i.e., the RMSE values are below 5 mV for both methods). The validity of the estimation is examined by checking the alignment of the peaks in the $dV/dQ$ curves as shown in Fig. 9(c) and Fig. 9(d). As can be seen in Fig. 9(c), the VF method does not guarantee a perfect alignment of the peaks. This is because the VF method does not take into account the peak information in estimating the parameters, but it still shows reasonable fit in the $dV/dQ$ curve for the fresh cell.

Identifying the electrode parameters decouples the electrodes as shown in Fig. 9(e) and Fig. 9(f). The dashed line of each electrode potential represents the full range and the solid line indicates the actual utilization range in the cell illustrated by $[y_{100}, y_0]$, $[x_{100}, x_0]$. The capacity associated with the full range is the capacity of the PE $C_p$ and NE $C_n$, respectively. Like typical cell design, both electrodes have excess amount of capacities over the cell capacity and the NE has larger capacity than the PE. Lastly, the estimated cell capacity $C$ is denoted with its error. The capacity estimates are very accurate less than 0.1% error when the whole OCV curve data is available. The slight misalignment in Fig. 9(c) explains the deviation of the parameter estimates from the two methods, but the deviation is small.

(2) Aged cell: The estimation results of the aged cell are summarized in Figs. 10(a) to 10(f). In estimation, the same OCV model is used (i.e., no changes in the half-cell potentials are considered). The RMSE values in Fig. 10(a) and Fig. 10(b) have increased in both methods, but the PA method has a more significant increase (23.9 mV) while the VF method still shows a relatively good agreement between the data and model. However, the VF method shows a substantial misalignment of the peaks in the $dV/dQ$ curves in Fig. 10(c). The peak at higher SOC is drifted by 5.14% of the normalized cell capacity, even though the cell capacity is estimated very accurately. Recall the fact that the alignment of peaks implies the correct estimation of the NE contribution in the full-cell, the observed misalignment from the VF method indicates the estimation results are incorrect. To be specific, the NE capacity $C_n$ shows 17% discrepancy between the two methods and consequently the utilization range of the NE becomes quite different. Note that the NE utilization at the fully discharged state $x_0$ is critical to identify the utilized graphite anode potential, as can be seen in Fig. 10(e), the estimate from the VF method on $x_0 = 0.01$ corresponds to an abrupt increase of the graphite half-cell potential and attributes the knee of the NMC/graphite cell's OCV curve to the NE only. This identified NE utilization results in smaller utilization range and less capacity reduction in the PE for the VF method, showing 16% difference in the PE capacity $C_p$ in two methods. Throughout this comparison, it is found that a good agreement in the voltage curve and the precise cell capacity estimation from the conventional VF method do not always provide an accurate electrode parameter estimation for the NMC/graphite cell that has been aged under the elevated temperature. On the contrary, in the proposed PA method, since the peaks are forced to be aligned between the data and model, at least the NE parameters are able to be accurately estimated using Eq. (2.11). The NE estimates indicate the knee of the cell OCV curve comes from both electrode potentials, and lead to the estimate of the PE capacity reduction by 36% from the fresh cell indicating $\text{LAM}_{\text{PE}}$ as one of the main degradation modes. However, a discernible mismatch is observed in the $dV/dQ$ curves around the high SOC region as shown in Fig. 10(d) contributing to the voltage error as well. According to the PA method, once the NE parameters are identified the PE parameters $\theta_p = [C_p, y_{100}]$ are estimated by fitting the PE half-cell potential function $U\text{-}p\,(y)$ to the extracted PE potential $\tilde{U}_p(Q)$ as described in $P2.2$. When the same PE half-cell potential function is used assuming no change in the half-cell potential curve, it is not able to obtain a good fit in the voltage curve by only tuning the PE parameters $\theta_p = [C_p, y_{100}]$, which suggests another possible aging effect, i.e., the half-cell potential curve change. To mitigate this mismatch, calibration of the half-cell potential function is further considered.

(3) Aged cell with half-cell potential calibration: With the invariance assumption of the electrode potentials, both conventional approaches show limitations; the misalignment of the peaks were found in the VF method indicating the incorrect estimation, and the substantial increase of RMSE and the mismatch in the $dV/dQ$ curves were observed from the PA method with the same half-cell potential functions. To rectify these shortcomings, the idea of calibrating the half-cell potential function is proposed. With the calibration, the refitted $\hat{U}_p(y)$ function is believed to reflect the changes in the half-cell potential curve due to aging, and consequently the estimated PE parameters are more accurate than the case without the calibration. The refitted $\hat{U}(y)$ function is then fed to both VF and PA methods for an update in the OCV model. With this update, electrode parameter estimation results in Figs. 11(a) to 11(f) show a very good agreement in the voltage curves between the data and model, and no more discernible mismatch is observed in the $dV/dQ$ curves. Similarly, the estimated electrode parameters from two methods show an excellent agreement.

The calibrated PE half-cell potential curve is plotted in Fig. 12 showing the evolution of the aged half-cell potential curve. Compared to the fresh half-cell potential, the aged one is shifted up overall and also to the left slightly. Specifically, the voltage curve above 3.8 V shows a drift to a higher voltage. This overall shift-up of the average potential due to aging agrees with a study in the literature (Ref. 2.35) on cycling behavior of the NCM/graphite cell.

(4) Electrode aging diagnostics: In Table 2.2, one of the most significant changes of the electrode parameters in the aged cell is the decrease of the PE capacity $C_p$. This decrease indicates the loss of PE active material, i.e., 28% of $\text{LAM}_{\text{PE}}$. We presume the dissolution of the transition metals in the NMC PE and associated with SEI layer growth, which consumes cyclable lithium at both electrodes, are taken place in the test cells, among 9% of $\text{LAM}_{\text{NE}}$ and 28% of LLI according to the definition of the degradation modes in Section II-B.

TABLE 2.2

**THE PARAMETER ESTIMATES AND THEIR CHANGES FROM THE FRESH TO AGED CELLS USING TWO METHODS**

| Parameter Estimates | Fresh Cell | | Aged Cell | | Aged Cell with Calibration | |
|---|---|---|---|---|---|---|
| | Voltage Fitting | Peak Alignment | Voltage Fitting | Peak Alignment | Voltage Fitting | Peak Alignment |
| $C_p$ [$y_0$, $y_{100}$] | 1.16 [0.97, 0.10] | **1.15** [0.97, 0.10] | 0.90 (-22%) [0.81, 0.11] (-19%, range) | 0.74 (-36%) [0.97, 0.09] (+1%, range) | 0.84 (-28%) [0.95, 0.17] (-10%, range) | 0.83 (-28%) [0.96, 0.16] (-8%, range) |
| $C_n$ [$x_0$, $x_{100}$] | 1.25 [0.04, 0.84] | 1.26 [0.05, 0.84] | 0.98 (-22%) [0.01, 0.68] (-16%, range) | 1.15 (-9%) [0.04, 0.61] (-28%, range) | 1.13 (-10%) [0.03, 0.61] (-28%, range) | 1.15 (-9%) [0.04, 0.61] (-28%, range) |
| $C$ | 1.00 | 1.00 | 0.66 (-34%) | 0.66 (-34%) | 0.66 (-34%) | 0.66 (-34%) |
| **OCV RMSE** | 3.8 mV | 4.4 mV | 5.7 mV | 23.9 mV | 2.1 mV | 3.1 mV |
| **Peak Match** | aligned | aligned | misaligned | aligned | aligned | aligned |

Conclusion

A novel combination of two conventional electrode parameter estimation approaches (i.e., voltage fitting and differential voltage analysis) for aging diagnostics in Li-ion batteries is disclosed. One limitation of the conventional voltage fitting (VF) method is that it does not necessarily guarantee the alignment of the peaks in the $dV/dQ$ curve. This is because the peak information, which is discernible in the differential voltage, are not explicitly considered in the least-squares fitting formulation. Furthermore, since this method only relies on the voltage the graphite NE, which has relatively low and flat voltage curve, has poor observability in electrode parameter estimation. On the other hand, since the proposed peak alignment (PA) method explicitly uses the peak information for the estimation, it can separate the individual electrode potentials from the cell voltage. Thus, the graphite NE parameters can be directly estimated by scaling and sliding for the peak location in the $dV/dQ$ curve. Once the NE utilization is identified, the utilized potential of the PE can be simply extracted by adding the cell OCV and the utilized NE potential. Hence, even if the PE does not have distinct peaks to be used, the PA method still can estimate the PE parameters with the reduced number of the unknown parameters by applying the least-squares fitting only for the PE potential. This electrode separation makes the developed PA method to be more robust on electrode SOH estimation.

The electrode parameters are estimated with a full range of the pseudo-OCV data from two methods without considering the half-cell potential change in a fresh cell and an aged cell. For the fresh cell case, two methods showed a good agreement. However, in the aged cell case, which has been cycled under a high temperature of 45°C until it reached beyond the typical EOL criteria (i.e., the SOH of the aged cell is 66%), the VF method showed a substantial misalignment of the peaks in the $dV/dQ$ curves, even though it still provided an accurate cell capacity estimate and a good voltage fit. This discrepancy is from the assumption on the invariance of the half-cell potentials, which can deteriorate the accuracy of electrode parameter estimation when that assumption is no longer maintained. To address this issue, the idea of calibrating the half-cell potential function was proposed by refitting the coefficients of the $U_p(y)$ basis functions. Applying the developed PA method showed a significant decrease in the capacity of the positive electrode $C_p$ indicating LAM$_{PE}$ and LLI as the main degradation modes. It is likely due to the dissolution of the transition metal and resulting in SEI layer growth that consumes cyclable lithium, which could be accelerated at the elevated temperature of our aging condition. The identified aged half-cell potential of the NMC positive electrode showed an overall shifting-up pattern agreed with the cycling behavior of the NMC/graphite cell in the literature.

Thus, the invention provides a method for accurately measuring the state of health in battery cells that contain an electrode that does not exhibit distinct phase transitions during charging and discharging.

REFERENCES:

[1.1] S. J. Moura, M. Krstic, and N. A. Chaturvedi, "Adaptive pde observer for battery SOC/SOH estimation," in ASME 2012 5th Annual Dynamic Systems and Control Conference joint with the JSME 2012 11th Motion and Vibration Conference, pp. 101-110, American Society of Mechanical Engineers, 2012.

[1.2] C. Weng, Y. Cui, J. Sun, and H. Peng, "On-board state of health monitoring of lithium-ion batteries using incremental capacity analysis with support vector regression," Journal of Power Sources, vol. 235, pp. 36-44, 2013.

[1.3] G. K. Prasad and C. D. Rahn, "Model based identification of aging parameters in lithium ion batteries," Journal of power sources, vol. 232, pp. 79-85, 2013.

[1.4] X. Han, M. Ouyang, L. Lu, J. Li, Y. Zheng, and Z. Li, "A comparative study of commercial lithium ion battery cycle life in electrical vehicle: Aging mechanism identification," Journal of Power Sources, vol. 251, pp. 38-54, 2014.

[1.5] C. R. Birkl, M. R. Roberts, E. McTurk, P. G. Bruce, and D. A. Howey, "Degradation diagnostics for lithium ion cells," Journal of Power Sources, vol. 341, pp. 373-386, 2017.

[1.6] P. Mohtat, F. Nezampasandarbabi, S. Mohan, J. B. Siegel, and A.G. Stefanopoulou, "On identifying the aging mechanisms in Li-ion batteries using two points measurements," in American Control Conference (ACC), 2017, pp. 98-103, IEEE, 2017.

[1.7] S. Lee, P. Mohtat, J. B. Siegel, and A.G. Stefanopoulou, "Beyond estimating battery state of health: identifiability of individual electrode capacity and utilization," in American Control Conference (ACC), 2018, IEEE, 2018 (in press).

[1.8] A. Bartlett, J. Marcicki, S. Onori, G. Rizzoni, X. G. Yang, and T. Miller, "Electrochemical model-based state of charge and capacity estimation for a composite electrode lithium-ion battery," IEEE Transactions on Control Systems Technology, vol. 24, no. 2, pp. 384-399, 2016.

[1.9] C. Uhlmann, J. Illig, M. Ender, R. Schuster, and E. Ivers-Tiffée, "In situ detection of lithium metal plating on graphite in experimental cells," Journal of Power Sources, vol. 279, pp. 428-438, 2015.

[1.10] S. Lee, J. B. Siegel, A. G. Stefanopoulou, J.-W. Lee, and T.-K. Lee, "Comparison of individual-electrode state of health estimation methods for lithium ion battery," in Dynamic Systems and Control Conference (DSCC), 2018, ASME, 2018 (in press).

[1.11] P. Liu, J. Wang, J. Hicks-Garner, E. Sherman, S. Soukiazian, M. Verbrugge, H. Tataria, J. Musser, and P. Finamore, "Aging mechanisms of lifepo4 batteries deduced by electrochemical and structural analyses," Journal of the Electrochemical Society, vol. 157, no. 4, pp. A499- A507, 2010.

[1.12] B. Stiaszny, J. C. Ziegler, E. E. Krauß, J. P. Schmidt, and E. Ivers-Tiffée, "Electrochemical characterization and post-mortem analysis of aged limn2o4-li (ni0. 5mn0. 3co0. 2) o2/graphite lithium ion batteries. part i: Cycle aging," Journal of Power Sources, vol. 251, pp. 439-450, 2014.

[1.13] A. Marongiu, N. Nlandi, Y. Rong, and D. U. Sauer, "On-board capacity estimation of lithium iron phosphate batteries by means of half-cell curves," Journal of Power Sources, vol. 324, pp. 158-169, 2016.

[1.14] S. Schindler and M. A. Danzer, "A novel mechanistic modeling framework for analysis of electrode balancing and degradation modes in commercial lithium-ion cells," Journal of Power Sources, vol. 343, pp. 226-236, 2017.

[1.15] J. Dahn, "Phase diagram of li x c 6," Physical Review B, vol. 44, no. 17, p. 9170, 1991.

[1.16] I. Bloom, L. K. Walker, J. K. Basco, D. P. Abraham, J. P. Christophersen, and C. D. Ho, "Differential voltage analyses of high-power lithium-ion cells. 4. cells containing NMC," Journal of Power Sources, vol. 195, no. 3, pp. 877-882, 2010.

[1.17] J. Wang, J. Purewal, P. Liu, J. Hicks-Garner, S. Soukazian, E. Sherman, A. Sorenson, L. Vu, H. Tataria, and M. W. Verbrugge, "Degradation of lithium ion batteries employing graphite negatives and nickel-cobalt- manganese oxide+ spinel manganese oxide positives: Part 1, aging mechanisms and life estimation," Journal of Power Sources, vol. 269, pp. 937-948, 2014.

[1.18] H. M. Dahn, A. Smith, J. Burns, D. Stevens, and J. Dahn, "User-friendly differential voltage analysis freeware for the analysis of degradation mechanisms in li-ion batteries," Journal of The Electrochemical Society, vol. 159, no. 9, pp. A1405-A1409, 2012.

[1.19] W. Choi and A. Manthiram, "Comparison of metal ion dissolutions from lithium ion battery cathodes," Journal of The Electrochemical Society, vol. 153, no. 9, pp. A1760-A1764, 2006.

[1.20] H. Zheng, Q. Sun, G. Liu, X. Song, and V. S. Battaglia, "Correlation between dissolution behavior and electrochemical cycling performance for lini1/3co1/3mn1/3o2-based cells," Journal of Power Sources, vol. 207, pp. 134-140, 2012.

[1.21] T. Waldmann, M. Wilka, M. Kasper, M. Fleischhammer, and M. Wohlfahrt-Mehrens, "Temperature dependent ageing mechanisms in lithium-ion batteries-a post-mortem study," Journal of Power Sources, vol. 262, pp. 129-135, 2014.

[1.22] J. Shim, R. Kostecki, T. Richardson, X. Song, and K. A. Striebel, "Electrochemical analysis for cycle performance and capacity fading of a lithium-ion battery cycled at elevated temperature," Journal of power sources, vol. 112, no. 1, pp. 222-230, 2002.

[1.23] K. Jalkanen, J. Karppinen, L. Skogström, T. Laurila, M. Nisula, and K. Vuorilehto, "Cycle aging of commercial NMC/graphite pouch cells at different temperatures," Applied energy, vol. 154, pp. 160-172, 2015.

[1.24] O. Dolotko, A. Senyshyn, M. Mühlbauer, K. Nikolowski, and H. Ehrenberg, "Understanding structural changes in NMC Li-ion cells by in situ neutron diffraction," Journal of Power Sources, vol. 255, pp. 197-203, 2014.

[2.1] S. J. Moura, M. Krstic, and N. A. Chaturvedi, "Adaptive pde observer for battery SOC/SOH estimation," in ASME 2012 5th Annual Dynamic Systems and Control Conference joint with the JSME 2012 11th Motion and Vibration Conference, pp. 101-110, American Society of Mechanical Engineers, 2012.

[2.2] C. Weng, Y. Cui, J. Sun, and H. Peng, "On-board state of health monitoring of lithium-ion batteries using incremental capacity analysis with support vector regression," Journal of Power Sources, vol. 235, pp. 36-44, 2013.

[2.3] Z. Guo, X. Qiu, G. Hou, B. Y. Liaw, and C. Zhang, "State of health estimation for lithium ion batteries based on charging curves," Journal of Power Sources, vol. 249, pp. 457-462, 2014.

[2.4] G. K. Prasad and C. D. Rahn, "Model based identification of aging parameters in lithium ion batteries," Journal of power sources, vol. 232, pp. 79-85, 2013.

[2.5] C. Uhlmann, J. Illig, M. Ender, R. Schuster, and E. Ivers-Tiffée, "In situ detection of lithium metal plating on graphite in experimental cells," Journal of Power Sources, vol. 279, pp. 428-438, 2015.

[2.6] I. Bloom, A. N. Jansen, D. P. Abraham, J. Knuth, S. A. Jones, V. S. Battaglia, and G. L. Henriksen, "Differential voltage analyses of high power, lithium-ion cells: 1. technique and application," Journal of Power Sources, vol. 139, no. 1-2, pp. 295-303, 2005.

[2.7] M. Dubarry, C. Truchot, and B. Y. Liaw, "Synthesize battery degradation modes via a diagnostic and prognostic model," Journal of power sources, vol. 219, pp. 204-216, 2012.

[2.8] X. Han, M. Ouyang, L. Lu, J. Li, Y. Zheng, and Z. Li, "A comparative study of commercial lithium ion battery cycle life in electrical vehicle: Aging mechanism identification," Journal of Power Sources, vol. 251, pp. 38-54, 2014.

[2.9] C. R. Birkl, M. R. Roberts, E. McTurk, P. G. Bruce, and D. A. Howey, "Degradation diagnostics for lithium ion cells," Journal of Power Sources, vol. 341, pp. 373-386, 2017.

[2.10] C. R. Birkl, E. McTurk, S. Zekoll, F. H. Richter, M. R. Roberts, P. G. Bruce, and D. A. Howey, "Degradation diagnostics for commercial lithium-ion cells tested at -10_c," Journal of The Electrochemical Society, vol. 164, no. 12, pp. A2644-A2653, 2017.

[2.11] A. Bartlett, J. Marcicki, S. Onori, G. Rizzoni, X. G. Yang, and T. Miller, "Electrochemical model-based state of charge and capacity estimation for a composite electrode lithium-ion battery," IEEE Transactions on Control Systems Technology, vol. 24, no. 2, pp. 384-399, 2016.

[2.12] K. Honkura, H. Honbo, Y. Koishikawa, and T. Horiba, "State analysis of lithium-ion batteries using discharge curves," ECS Transactions, vol. 13, no. 19, pp. 61-73, 2008.

[2.13] H. M. Dahn, A. Smith, J. Burns, D. Stevens, and J. Dahn, "User-friendly differential voltage analysis freeware for the analysis of degradation mechanisms in li-ion batteries," Journal of The Electrochemical Society, vol. 159, no. 9, pp. A1405-A1409, 2012.

[2.14] J. Wang, J. Purewal, P. Liu, J. Hicks-Garner, S. Soukazian, E. Sherman, A. Sorenson, L. Vu, H. Tataria, and M. W. Verbrugge, "Degradation of lithium ion batteries employing graphite negatives and nickel-cobalt- manganese oxide+ spinel manganese oxide positives: Part 1, aging mechanisms and life estimation," Journal of Power Sources, vol. 269, pp. 937-948, 2014.

[2.15] M. Dubarry, M. Berecibar, A. Devie, D. Anseán, N. Omar, and I. Villarreal, "State of health battery estimator enabling degradation diagnosis: Model and algorithm description," Journal of Power Sources, vol. 360, pp. 59-69, 2017.

[16] J. Dahn, "Phase diagram of lixc6," Physical Review B, vol. 44, no. 17, p. 9170, 1991.

[2.17] I. Bloom, L. K. Walker, J. K. Basco, D. P. Abraham, J. P. Christophersen, and C. D. Ho, "Differential voltage analyses of high-power lithium-ion cells. 4. cells containing NMC," Journal of Power Sources, vol. 195, no. 3, pp. 877-882, 2010.

[2.18] A. Marongiu, N. Nlandi, Y. Rong, and D. U. Sauer, "On-board capacity estimation of lithium iron phosphate batteries by means of half-cell curves," Journal of Power Sources, vol. 324, pp. 158-169, 2016.

[2.19] P. Liu, J. Wang, J. Hicks-Garner, E. Sherman, S. Soukiazian, M. Verbrugge, H. Tataria, J. Musser, and P. Finamore, "Aging mechanisms of lifepo4 batteries deduced by electrochemical and structural analyses," Journal of the Electrochemical Society, vol. 157, no. 4, pp. A499- A507, 2010.

[2.20] B. Stiaszny, J. C. Ziegler, E. E. Krauß, J. P. Schmidt, and E. Ivers-Tiffée, "Electrochemical characterization and post-mortem analysis of aged limn2o4-li (ni0. 5mn0. 3co0. 2) o2/graphite lithium ion batteries. part i: Cycle aging," Journal of Power Sources, vol. 251, pp. 439-450, 2014.

[2.21] I. Bloom, J. P. Christophersen, D. P. Abraham, and K. L. Gering, "Differential voltage analyses of high-power lithium-ion cells: 3. another anode phenomenon," Journal of power sources, vol. 157, no. 1, pp. 537-542, 2006.

[2.22] S. Lee, J. B. Siegel, A. G. Stefanopoulou, J.-W. Lee, and T.-K. Lee, "Comparison of individual-electrode state of health estimation methods for lithium ion battery," in ASME 2018 Dynamic Systems and Control Conference, pp. V002T19A002-V002T19A002, American Society of Mechanical Engineers, 2018.

[2.23] S. Lee, P. Mohtat, J. B. Siegel, and A. G. Stefanopoulou, "Beyond estimating battery state of health: Identifiability of individual electrode capacity and utilization," in 2018 Annual American Control Conference (ACC), pp. 2288-2293, IEEE, 2018.

[2.24] D. K. Karthikeyan, G. Sikha, and R. E. White, "Thermodynamic model development for lithium intercalation electrodes," Journal of Power Sources, vol. 185, no. 2, pp. 1398-1407, 2008.

[2.25] S. G. Stewart, V. Srinivasan, and J. Newman, "Modeling the performance of lithium-ion batteries and capacitors during hybrid-electric vehicle operation," Journal of The Electrochemical Society, vol. 155, no. 9, pp. A664-A671, 2008.

[2.26] M. Safari and C. Delacourt, "Modeling of a commercial graphite/lifepo4 cell," Journal of the Electrochemical Society, vol. 158, no. 5, pp. A562-A571, 2011.

[2.27] G. Plett, Battery Management Systems, Volume I: Battery Modeling. No. v. 1 in Artech House power engineering series, Artech House, 2015.

[2.28] M. Wohlfahrt-Mehrens, C. Vogler, and J. Garche, "Aging mechanisms of lithium cathode materials," Journal of power sources, vol. 127, no. 1-2, pp. 58-64, 2004. [2.29] C. Julien, A. Mauger, K. Zaghib, and H. Groult, "Comparative issues of cathode materials for li-ion batteries," Inorganics, vol. 2, no. 1, pp. 132-154, 2014.

[2.30] W. Choi and A. Manthiram, "Comparison of metal ion dissolutions from lithium ion battery cathodes," Journal of The Electrochemical Society, vol. 153, no. 9, pp. A1760-A1764, 2006.

[2.31] H. Zheng, Q. Sun, G. Liu, X. Song, and V. S. Battaglia, "Correlation between dissolution behavior and electrochemical cycling performance for lini1/3co1/3mn1/3o2-based cells," Journal of Power Sources, vol. 207, pp. 134-140, 2012.

[2.32] T. Waldmann, M. Wilka, M. Kasper, M. Fleischhammer, and M. Wohlfahrt-Mehrens, "Temperature dependent ageing mechanisms in lithium-ion batteries-a post-mortem study," Journal of Power Sources, vol. 262, pp. 129-135, 2014.

[2.33] J. Shim, R. Kostecki, T. Richardson, X. Song, and K. A. Striebel, "Electrochemical analysis for cycle performance and capacity fading of a lithium-ion battery cycled at elevated temperature," Journal of power sources, vol. 112, no. 1, pp. 222-230, 2002.

[2.34] K. Jalkanen, J. Karppinen, L. Skogström, T. Laurila, M. Nisula, and K. Vuorilehto, "Cycle aging of commercial NMC/graphite pouch cells at different temperatures," Applied energy, vol. 154, pp. 160-172, 2015.

[2.35] J. A. Gilbert, J. Bareño, T. Spila, S. E. Trask, D. J. Miller, B. J. Polzin, A. N. Jansen, and D. P. Abraham, "Cycling behavior of ncm523/graphite lithium-ion cells in the 3-4.4 v range: diagnostic studies of full cells and harvested electrodes," Journal of The Electrochemical Society, vol. 164, no. 1, pp. A6054-A6065, 2017.

**Claims**

1. An electrical device, comprising:

   a battery cell;
   a voltage sensor operatively coupled to the battery cell in order to measure a voltage level of the battery cell;
   a current sensor operatively coupled to the battery cell in order to measure an amount of current drawn from the battery cell; and
   a battery management system including a controller in electrical communication with the voltage sensor and the current sensor, the controller being configured to execute a program stored in the controller to:

   (i) receive a plurality of voltage values from the voltage sensor,
   (ii) receive a plurality of current values from the current sensor,

   wherein each current value is associated with one of the voltage values,

   (iii) calculate a plurality of total discharge values, wherein each total discharge value is associated with one of the current values,
   (iv) calculate a differential voltage curve using the voltage values and the total discharge values,
   (v) determine a first differential voltage point and a second differential voltage point on the differential voltage curve wherein each of the first differential voltage point and second differential voltage point is at a local peak, and
   (vi) calculate a state of health of the battery cell using the first differential voltage point, the second differential voltage point, and a characteristic curve of a reference battery electrode of a reference battery cell, wherein the reference battery cell includes a second reference battery electrode not exhibiting distinct phase transitions during a charge - discharge cycle.

2. The device of claim 1, wherein the differential voltage curve has local peaks originating from an anode or a cathode.

3. The device of claim 1, wherein the characteristic curve is a differential voltage curve of the reference battery electrode.

4. The device of claim 1, wherein
the controller is configured to execute the program stored in the controller to calculate the state of health of the battery cell based on a utilization range calculated based on a lower bound of a utilization range of an anode of the battery cell.

5. The device of claim 1, wherein
the controller is configured to execute the program stored in the controller to calculate the state of health of the battery cell based on an upper bound of a utilization range of an anode of the battery cell.

6. The device of claim 1, wherein
the controller is configured to execute the program stored in the controller to calculate the state of health of the battery cell based on an electrode capacity of an anode of the battery cell.

7. The device of claim 1, further comprising:

a temperature sensor operatively coupled to the battery cell in order to measure a temperature of the battery cell; wherein the controller is in electrical communication with the temperature sensor, and wherein the controller is configured to execute the program stored in the controller to calculate the state of health of the battery cell based on the temperature of the battery cell.

8. The device of claim 1, wherein:
the controller is configured to execute the program stored in the controller to calculate a negative electrode parameter from the first differential voltage point and the second differential voltage point.

9. The device of claim 8, wherein:
the controller is configured to execute the program stored in the controller to calculate a positive electrode potential from the negative electrode parameter.

10. The device of claim 1, wherein:
the controller is configured to execute the program stored in the controller to calculate a positive electrode parameter from the first differential voltage point and the second differential voltage point.

11. The device of claim 10, wherein:
the controller is configured to execute the program stored in the controller to calculate a negative electrode potential from the positive electrode parameter.

12. The device of claim 9, wherein:
the controller is configured to execute the program stored in the controller to calculate a positive electrode parameter from the positive electrode potential.

13. The device of claim 11, wherein:
the controller is configured to execute the program stored in the controller to calculate a negative electrode parameter from the negative electrode potential.

14. A method for determining the state of health percentage of a battery cell, the method comprising:

measuring voltage in a battery cell;
measuring current drawn from a battery cell; and
calculating in a controller a state of health of the battery cell based on (i) the voltage measured, (ii) the current measured, (iii) a total discharge calculated based on the current measured, (iv) a differential voltage curve calculated based on the voltage measured and the total discharge calculated, (v) a first differential voltage point and a second differential voltage point, wherein each of the first differential voltage point and the second differential voltage point is at a local peak, (vi) a characteristic curve of a reference battery electrode of a reference battery cell, wherein the reference battery cell includes a second reference battery electrode not exhibiting distinct phase transitions during a charge - discharge cycle.

15. A method in a data processing system comprising at least one processor and at least one memory, the at least one memory comprising instructions executed by the at least one processor to implement a battery state of health estimation system, the method comprising:

(a) receiving a plurality of voltage values from a voltage sensor operatively coupled to a battery cell;

(b) receiving a plurality of current values from a current sensor operatively coupled to the battery cell, each current value being associated with one of the voltage values included in the plurality of voltage values;

(c) calculating a plurality of total discharge values, each total discharge value being associated with one of the current values included in the plurality of current values;

(d) calculating a differential voltage curve based on the voltage values and the total discharge values;

(e) determining a first differential voltage point and a second differential voltage point on the differential voltage curve wherein each of the first differential voltage point and second differential voltage point is at a local peak;

(f) determining a first set of positive electrode potential values from the differential voltage curve;

(g) determining a measure of fit based on the positive electrode potential values;

(h) comparing the measure of fit to a predetermined threshold; and

(i) estimating a state of health of the battery cell, wherein the state of health of the battery cell is estimated using the first set of positive electrode potential values when the measure of fit is at or below the predetermined threshold, and wherein the state of health of the battery cell is estimated using a second set of positive electrode potential values calculated based on the plurality of total discharge values when the measure of fit is above the predetermined threshold.

**Patentansprüche**

1.  Elektrische Vorrichtung, umfassend:

    eine Batteriezelle;

    einen Spannungssensor, der betriebsfähig mit der Batteriezelle gekoppelt ist, um einen Spannungspegel der Batteriezelle zu messen;

    einen Stromsensor, der betriebsfähig mit der Batteriezelle gekoppelt ist, um eine Strommenge zu messen, die von der Batteriezelle gezogen wird; und

    ein Batterieverwaltungssystem, das eine Steuervorrichtung beinhaltet, die in elektrischer Verbindung mit dem Spannungssensor und dem Stromsensor steht, wobei die Steuervorrichtung dazu konfiguriert ist, ein Programm auszuführen, das in der Steuervorrichtung gespeichert ist, zum:

    (i) Empfangen einer Mehrzahl von Spannungswerten von dem Spannungssensor,

    (ii) Empfangen einer Mehrzahl von Stromwerten von dem Stromsensor, wobei jeder Stromwert einem der Spannungswerte zugeordnet ist,

    (iii) Berechnen einer Mehrzahl von Gesamtentladungswerten, wobei jeder Gesamtentladungswert einem der Stromwerte zugeordnet ist,

    (iv) Berechnen einer Differenzspannungskurve unter Verwendung der Spannungswerte und der Gesamtentladungswerte,

    (v) Bestimmen eines ersten Differenzspannungspunkts und eines zweiten Differenzspannungspunkts auf der Differentialspannungskurve, wobei der erste Differentialspannungspunkt und der zweite Differentialspannungspunkt jeweils an einer lokalen Spitze liegen, und

    (vi) Berechnen eines Gesundheitszustands der Batteriezelle unter Verwendung des ersten Differenzspannungspunkts, des zweiten Differenzspannungspunkts und einer Kennlinie einer Referenzbatterieelektrode einer Referenzbatteriezelle, wobei die Referenzbatteriezelle eine zweite Referenzbatterieelektrode beinhaltet, die während eines Lade-/Entladezyklus keine eindeutigen Phasenübergänge aufzeigt.

2.  Vorrichtung nach Anspruch 1, wobei die Differenzspannungskurve lokale Spitzen aufweist, die von einer Anode oder einer Kathode ausgehen.

3.  Vorrichtung nach Anspruch 1, wobei die Kennlinie eine Differenzspannungskurve der Referenzbatterieelektrode ist.

4.  Vorrichtung nach Anspruch 1, wobei
    die Steuervorrichtung dazu konfiguriert ist, das in der Steuervorrichtung gespeicherte Programm auszuführen, um den Zustand der Batteriezelle auf Grundlage eines Nutzungsbereichs zu berechnen, der auf Grundlage einer unteren Grenze eines Nutzungsbereichs einer Anode der Batteriezelle berechnet wird.

5.  Vorrichtung nach Anspruch 1, wobei
    die Steuervorrichtung dazu konfiguriert ist, das in der Steuervorrichtung gespeicherte Programm auszuführen, um den Zustand der Batteriezelle auf Grundlage einer oberen Grenze eines Nutzungsbereichs einer Anode der Batteriezelle zu berechnen.

6. Vorrichtung nach Anspruch 1, wobei
die Steuervorrichtung dazu konfiguriert ist, das in der Steuervorrichtung gespeicherte Programm auszuführen, um den Zustand der Batteriezelle auf Grundlage einer Elektrodenkapazität einer Anode der Batteriezelle zu berechnen.

7. Vorrichtung nach Anspruch 1, die ferner umfasst:

einen Temperatursensor, der betriebsfähig mit der Batteriezelle gekoppelt ist, um eine Temperatur der Batteriezelle zu messen;
wobei die Steuervorrichtung in elektrischer Verbindung mit dem Temperatursensor steht, und
wobei die Steuervorrichtung dazu konfiguriert ist, das in der Steuervorrichtung gespeicherte Programm auszuführen, um den Gesundheitszustand der Batteriezelle auf Grundlage der Temperatur der Batteriezelle zu berechnen.

8. Vorrichtung nach Anspruch 1, wobei:
die Steuervorrichtung dazu konfiguriert ist, das in der Steuervorrichtung gespeicherte Programm auszuführen, um einen negativen Elektrodenparameter aus dem ersten Differenzspannungspunkt und dem zweiten Differenzspannungspunkt zu berechnen.

9. Vorrichtung nach Anspruch 8, wobei:
die Steuervorrichtung dazu konfiguriert ist, das in der Steuervorrichtung gespeicherte Programm auszuführen, um ein positives Elektrodenpotential aus dem negativen Elektrodenparameter zu berechnen.

10. Vorrichtung nach Anspruch 1, wobei:
die Steuervorrichtung dazu konfiguriert ist, das in der Steuervorrichtung gespeicherte Programm auszuführen, um einen positiven Elektrodenparameter aus dem ersten Differenzspannungspunkt und dem zweiten Differenzspannungspunkt zu berechnen.

11. Vorrichtung nach Anspruch 10, wobei:
die Steuervorrichtung dazu konfiguriert ist, das in der Steuervorrichtung gespeicherte Programm auszuführen, um ein negatives Elektrodenpotential aus dem positiven Elektrodenparameter auszuführen.

12. Vorrichtung nach Anspruch 9, wobei:
die Steuervorrichtung dazu konfiguriert ist, das in der Steuervorrichtung gespeicherte Programm auszuführen, um einen positiven Elektrodenparameter aus dem positiven Elektrodenpotential zu berechnen.

13. Vorrichtung nach Anspruch 11, wobei:
die Steuervorrichtung dazu konfiguriert ist, das in der Steuervorrichtung gespeicherte Programm auszuführen, um einen negativen Elektrodenparameter aus dem negativen Elektrodenpotential zu berechnen.

14. Verfahren zum Bestimmen des prozentualen Gesundheitszustands einer Batteriezelle, wobei das Verfahren umfasst:

Messen der Spannung in einer Batteriezelle;
Messen des von einer Batteriezelle gezogenen Stroms; und
Berechnen eines Gesundheitszustands der Batteriezelle in einer Steuervorrichtung auf Grundlage von (i) der gemessenen Spannung, (ii) dem gemessenen Strom, (iii) einer auf Grundlage des gemessenen Stroms berechneten Gesamtentladung, (iv) einer auf Grundlage der gemessenen Spannung und der berechneten Gesamtentladung berechneten Differenzspannungskurve, (v) einem ersten Differenzspannungspunkt und einem zweiten Differenzspannungspunkt, wobei der erste Differentialspannungspunkt und der zweite Differentialspannungspunkt jeweils an einer lokalen Spitze liegen, (vi) einer Kennlinie einer Referenzbatterieelektrode einer Referenzbatteriezelle, wobei die Referenzbatteriezelle eine zweite Referenzbatterieelektrode beinhaltet, die während eines Lade-/Entladezyklus keine eindeutigen Phasenübergänge aufzeigt.

15. Verfahren in einem Datenverarbeitungssystem, das wenigstens einen Prozessor und wenigstens einen Speicher umfasst, wobei der wenigstens eine Speicher Anweisungen umfasst, die von dem wenigstens einen Prozessor ausgeführt werden, um ein System für die Abschätzung des Gesundheitszustands einer Batterie zu implementieren, wobei das Verfahren umfasst:

(a) Empfangen einer Mehrzahl von Spannungswerten von einem Spannungssensor, der betriebsfähig mit einer Batteriezelle gekoppelt ist;

(b) Empfangen einer Mehrzahl von Stromwerten von einem Stromsensor, der betriebsfähig mit der Batteriezelle gekoppelt ist, wobei jeder Stromwert einem der Spannungswerte zugeordnet ist, die in der Mehrzahl von Spannungswerten beinhaltet sind;

(c) Berechnen einer Mehrzahl von Gesamtentladungswerten, wobei jeder Gesamtentladungswert einem der Stromwerte zugeordnet ist, die in der Mehrzahl der Stromwerte beinhaltet sind;

(d) Berechnen einer Differenzspannungskurve auf Grundlage der Spannungswerte und der Gesamtentladungswerte;

(e) Bestimmen eines ersten Differenzspannungspunkts und eines zweiten Differenzspannungspunkts auf der Differentialspannungskurve, wobei der erste Differentialspannungpunkt und der zweite Differentialspannungspunkt jeweils an einer lokalen Spitze liegen;

(f) Bestimmen eines ersten Satzes von positiven Elektrodenpotentialwerten aus der Differenzspannungskurve;

(g) Bestimmen eines Anpassungsmaßes auf Grundlage der positiven Elektrodenpotentialwerte;

(h) Vergleichen des Anpassungsmaßes mit einer vorbestimmten Schwelle; und

(i) Schätzen eines Gesundheitszustands der Batteriezelle, wobei der Gesundheitszustand der Batteriezelle unter Verwendung des ersten Satzes positiver Elektrodenpotentialwerte geschätzt wird, wenn das Anpassungsmaß bei oder unter der vorbestimmten Schwelle liegt, und wobei der Gesundheitszustand der Batteriezelle unter Verwendung eines zweiten Satzes von positiven Elektrodenpotentialwerten geschätzt wird, der auf Grundlage der Mehrzahl von Gesamtentladungswerten berechnet wird, wenn das Anpassungsmaß oberhalb der vorbestimmten Schwelle liegt.

**Revendications**

1. Dispositif électrique, comprenant :

une cellule de batterie ;

un capteur de tension fonctionnellement couplé à la cellule de batterie afin de mesurer un niveau de tension de la cellule de batterie ;

un capteur de courant fonctionnellement couplée à la cellule de batterie afin de mesurer une quantité de courant soutirée de la cellule de batterie ; et

un système de gestion de batterie incluant une unité de commande en communication électrique avec le capteur de tension et le capteur de courant, l'unité de commande étant configurée pour exécuter un programme stocké dans l'unité de commande pour :

(i) recevoir une pluralité de valeurs de tension en provenance du capteur de tension,

(ii) recevoir une pluralité de valeurs de courant en provenance du capteur de courant,

dans lequel chaque valeur de courant est associée à une des valeurs de tension,

(iii) calculer une pluralité de valeurs de décharge totale, dans lequel chaque valeur de décharge totale est associée à une des valeurs de courant,

(iv) calculer une courbe de tension différentielle en utilisant les valeurs de tension et les valeurs de décharge totale,

(v) déterminer un premier point de tension différentielle et un second point de tension différentielle sur la courbe de tension différentielle, dans lequel chacun du premier point de tension différentielle et du second point de tension différentielle est à un pic local, et

(vi) calculer un état de santé de la cellule de batterie en utilisant le premier point de tension différentielle, le second point de tension différentielle, et une courbe caractéristique d'une électrode de batterie de référence d'une cellule de batterie de référence, dans lequel la cellule de batterie de référence inclut une seconde électrode de batterie de référence ne présentant pas de transitions de phase distinctes durant un cycle charge - décharge.

2. Dispositif de la revendication 1, dans lequel la courbe de tension différentielle a des pic locaux provenant d'une anode ou d'une cathode.

3. Dispositif de la revendication 1, dans lequel la courbe caractéristique est une courbe de tension différentielle de l'électrode de batterie de référence.

4. Dispositif de la revendication 1, dans lequel
l'unité de commande est configurée pour exécuter le programme stocké dans l'unité de commande pour calculer l'état de santé de la cellule de batterie sur la base d'une plage d'utilisation calculée sur la base d'une limite inférieure d'une plage d'utilisation d'une anode de la cellule de batterie.

5. Dispositif de la revendication 1, dans lequel
l'unité de commande est configurée pour exécuter le programme stocké dans l'unité de commande pour calculer l'état de santé de la cellule de batterie sur la base d'une limite supérieure d'une plage d'utilisation d'une anode de la cellule de batterie.

6. Dispositif de la revendication 1, dans lequel
l'unité de commande est configurée pour exécuter le programme stocké dans l'unité de commande pour calculer l'état de santé de la cellule de batterie sur la base d'une capacité d'électrode d'une anode de la cellule de batterie.

7. Dispositif de la revendication 1, comprenant en outre :

un capteur de température fonctionnellement couplé à la cellule de batterie afin de mesurer une température de la cellule de batterie ;
dans lequel l'unité de commande est en communication électrique avec le capteur de température, et
dans lequel l'unité de commande est configurée pour exécuter le programme stocké dans l'unité de commande pour calculer l'état de santé de la cellule de batterie sur la base de la température de la cellule de batterie.

8. Dispositif de la revendication 1, dans lequel :
l'unité de commande est configurée pour exécuter le programme stocké dans l'unité de commande pour calculer un paramètre d'électrode négative à partir du premier point de tension différentielle et du second point de tension différentielle.

9. Dispositif de la revendication 8, dans lequel :
l'unité de commande est configurée pour exécuter le programme stocké dans l'unité de commande pour calculer un potentiel d'électrode positive à partir du paramètre d'électrode négative.

10. Dispositif de la revendication 1, dans lequel :
l'unité de commande est configurée pour exécuter le programme stocké dans l'unité de commande pour calculer un paramètre d'électrode positive à partir du premier point de tension différentielle et du second point de tension différentielle.

11. Dispositif de la revendication 10, dans lequel :
l'unité de commande est configurée pour exécuter le programme stocké dans l'unité de commande pour calculer un potentiel d'électrode négative à partir du paramètre d'électrode positive.

12. Dispositif de la revendication 9, dans lequel :
l'unité de commande est configurée pour exécuter le programme stocké dans l'unité de commande pour calculer un paramètre d'électrode positive à partir du potentiel d'électrode positive.

13. Dispositif de la revendication 11, dans lequel :
l'unité de commande est configurée pour exécuter le programme stocké dans l'unité de commande pour calculer un paramètre d'électrode négative à partir du potentiel d'électrode négative.

14. Procédé pour déterminer le pourcentage d'état de santé d'une cellule de batterie, le procédé comprenant :

la mesure de la tension dans une cellule de batterie ;
la mesure du courant soutiré d'une cellule de batterie ; et
le calcul, dans une unité de commande, d'un état de santé de la cellule de batterie sur la base (i) de la tension mesurée, (ii) du courant mesuré, (iii) d'une décharge totale calculée sur la base du courant mesuré, (iv) d'une courbe de tension différentielle calculée sur la base de la tension mesurée et de la décharge totale calculée, (v) d'un premier point de tension différentielle et d'un second point de tension différentielle, dans lequel chacun du premier point de tension différentielle et du second point de tension différentielle est à un pic local, (vi) d'une courbe caractéristique d'une électrode de batterie de référence d'une cellule de batterie de référence, dans lequel la cellule de batterie de référence inclut une seconde électrode de batterie de référence ne présentant pas de transitions de phase distinctes durant un cycle charge - décharge.

15. Procédé dans un système de traitement de données comprenant au moins un processeur et au moins une mémoire, l'au moins une mémoire comprenant des instructions exécutées par l'au moins un processeur pour mettre en œuvre un système d'estimation d'état de santé de batterie, le procédé comprenant :

(a) la réception d'une pluralité de valeurs de tension en provenance d'un capteur de tension fonctionnellement couplé à une cellule de batterie ;
(b) la réception d'une pluralité de valeurs de courant en provenance d'un capteur de courant fonctionnellement couplé à la cellule de batterie, chaque valeur de courant étant associée à une des valeurs de tension incluse dans la pluralité de valeurs de tension ;
(c) le calcul d'une pluralité de valeurs de décharge totale, chaque valeur de décharge totale étant associée à une des valeurs de courant incluse dans la pluralité de valeurs de courant ;
(d) le calcul d'une courbe de tension différentielle sur la base des valeurs de tension et des valeurs de décharge totale ;
(e) la détermination d'un premier point de tension différentielle et d'un second point de tension différentielle sur la courbe de tension différentielle, dans lequel chacun du premier point de tension différentielle et du second point de tension différentielle est à un pic local ;
(f) la détermination d'un premier ensemble de valeurs de potentiel d'électrode positive à partir de la courbe de tension différentielle ;
(g) la détermination d'une mesure d'ajustement sur la base des valeurs de potentiel d'électrode positive ;
(h) la comparaison de la mesure d'ajustement à un seuil prédéterminé ; et
(i) l'estimation d'un état de santé de la cellule de batterie, dans lequel l'état de santé de la cellule de batterie est estimé en utilisant le premier ensemble de valeurs de potentiel d'électrode positive lorsque la mesure d'ajustement est au seuil prédéterminé ou inférieurs à celui-ci, et dans lequel l'état de santé de la cellule de batterie est estimé en utilisant un second ensemble de valeurs de potentiel d'électrode positive calculées sur la base de la pluralité de valeurs de décharge totale lorsque la mesure d'ajustement est supérieure au seuil prédéterminé.

Fig. 1

Fig. 2

## Voltage Fitting

Fig. 3(a)

Fig. 3(c)

Fig. 3(e)

**Peak Alignment**

Fig. 3(b)

Fig. 3(d)

Fig. 3(f)

## Voltage Fitting

Fig. 4(a)

Fig. 4(c)

Fig. 4(e)

## Peak Alignment

Fig. 4(b)

Fig. 4(d)

Fig. 4(f)

Fig. 5(a)

Fig. 5(c)

Fig. 5(e)

Fig. 5(b)

Fig. 5(d)

Fig. 5(f)

Fig. 6

Fig. 7

Fig. 8

VF-Fresh cell

Fig. 9(a)

Fig. 9(c)

Fig. 9(e)

PA-Fresh cell

Fig. 9(b)

Fig. 9(d)

Fig. 9(f)

VF-Aged cell

Fig. 10(a)

Fig. 10(c)

Fig. 10(e)

PA-Aged cell

Fig. 10(b)

Fig. 10(d)

Fig. 10(f)

## VF-Aged cell with calibration

(a)

RMSE = 2.1 [mV]

Fig. 11(a)

(c)

1.0%

Fig. 11(c)

(e)

y100 = 0.17

y0 = 0.95

C = 0.66
(Error = 0.07%)

Cp = 0.84

Cn = 1.13

x100 = 0.61

x0 = 0.03

Fig. 11(e)

## PA-Aged cell with calibration

Fig. 11(b)

Fig. 11(d)

Fig. 11(f)

Fig. 12

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• US 2017038436 A1

**Non-patent literature cited in the description**

• **LEE SUHAK et al.** Beyond Estimating Battery State of Health: Identifiability of Individual Electrode Capacity and Utilization. *ANNUAL AMERICAN CONTROL CONE. (ACC)*, 27 June 2018, 2288-2293

• Differential voltage analyses of high-power, lithium-ion cells - 1. Technique and application. **BLOOM I et al.** J. of Power Sources. ELSEVIER, 04 January 2005, vol. 139, 295-303

• Adaptive pde observer for battery SOC/SOH estimation. **S. J. MOURA** ; **M. KRSTIC** ; **N. A. CHATURVEDI**. ASME 2012 5th Annual Dynamic Systems and Control Conference joint with the JSME 2012 11th Motion and Vibration Conference. American Society of Mechanical Engineers, 2012, 101-110

• **C. WENG** ; **Y. CUI** ; **J. SUN** ; **H. PENG**. On-board state of health monitoring of lithium-ion batteries using incremental capacity analysis with support vector regression. *Journal of Power Sources*, 2013, vol. 235, 36-44

• **G. K. PRASAD** ; **C. D. RAHN**. Model based identification of aging parameters in lithium ion batteries. *Journal of power sources*, 2013, vol. 232, 79-85

• **X. HAN** ; **M. OUYANG** ; **L. LU** ; **J. LI** ; **Y. ZHENG** ; **Z. LI**. A comparative study of commercial lithium ion battery cycle life in electrical vehicle: Aging mechanism identification. *Journal of Power Sources*, 2014, vol. 251, 38-54

• **C. R. BIRKL** ; **M. R. ROBERTS** ; **E. MCTURK** ; **P. G. BRUCE** ; **D. A. HOWEY**. Degradation diagnostics for lithium ion cells. *Journal of Power Sources*, 2017, vol. 341, 373-386

• On identifying the aging mechanisms in Li-ion batteries using two points measurements. **P. MOHTAT** ; **F. NEZAMPASANDARBABI** ; **S. MOHAN** ; **J. B. SIEGEL** ; **A.G. STEFANOPOULOU**. American Control Conference (ACC), 2017. IEEE, 2017, 98-103

• Beyond estimating battery state of health: identifiability of individual electrode capacity and utilization. **S. LEE** ; **P. MOHTAT** ; **J. B. SIEGEL** ; **A.G. STEFANOPOULOU**. American Control Conference (ACC), 2018. IEEE, 2018

• **A. BARTLETT** ; **J. MARCICKI** ; **S. ONORI** ; **G. RIZZONI** ; **X. G. YANG** ; **T. MILLER**. Electrochemical model-based state of charge and capacity estimation for a composite electrode lithium-ion battery. *IEEE Transactions on Control Systems Technology*, 2016, vol. 24 (2), 384-399

• **C. UHLMANN** ; **J. ILLIG** ; **M. ENDER** ; **R. SCHUSTER** ; **E. IVERS-TIFFÉE**. In situ detection of lithium metal plating on graphite in experimental cells. *Journal of Power Sources*, 2015, vol. 279, 428-438

• Comparison of individual-electrode state of health estimation methods for lithium ion battery. **S. LEE** ; **J. B. SIEGEL** ; **A. G. STEFANOPOULOU** ; **J.-W. LEE** ; **T.-K. LEE**. Dynamic Systems and Control Conference (DSCC), 2018. ASME, 2018

• **P. LIU** ; **J. WANG** ; **J. HICKS-GARNER** ; **E. SHERMAN** ; **S. SOUKIAZIAN** ; **M. VERBRUGGE** ; **H. TATARIA** ; **J. MUSSER** ; **P. FINAMORE**. Aging mechanisms of lifepo4 batteries deduced by electrochemical and structural analyses. *Journal of the Electrochemical Society*, 2010, vol. 157 (4), A499-A507

• **B. STIASZNY** ; **J. C. ZIEGLER** ; **E. E. KRAUß** ; **J. P. SCHMIDT** ; **E. IVERS-TIFFÉE**. Electrochemical characterization and post-mortem analysis of aged limn2o4-li (ni0. 5mn0. 3co0. 2) o2/graphite lithium ion batteries. part i: Cycle aging. *Journal of Power Sources*, 2014, vol. 251, 439-450

• **A. MARONGIU** ; **N. NLANDI** ; **Y. RONG** ; **D. U. SAUER**. On-board capacity estimation of lithium iron phosphate batteries by means of half-cell curves. *Journal of Power Sources*, 2016, vol. 324, 158-169

• **S. SCHINDLER** ; **M. A. DANZER**. A novel mechanistic modeling framework for analysis of electrode balancing and degradation modes in commercial lithium-ion cells. *Journal of Power Sources*, 2017, vol. 343, 226-236

• **J. DAHN**. Phase diagram of li x c 6. *Physical Review B*, 1991, vol. 44 (17), 9170

- **I. BLOOM** ; **L. K. WALKER** ; **J. K. BASCO** ; **D. P. ABRAHAM** ; **J. P. CHRISTOPHERSEN** ; **C. D. HO**. Differential voltage analyses of high-power lithium-ion cells. 4. cells containing NMC. *Journal of Power Sources*, 2010, vol. 195 (3), 877-882
- **J. WANG** ; **J. PUREWAL** ; **P. LIU** ; **J. HICKS-GARNER** ; **S. SOUKAZIAN** ; **E. SHERMAN** ; **A. SORENSON** ; **L. VU** ; **H. TATARIA** ; **M. W. VERBRUGGE**. Degradation of lithium ion batteries employing graphite negatives and nickel-cobalt-manganese oxide+ spinel manganese oxide positives: Part 1, aging mechanisms and life estimation. *Journal of Power Sources*, 2014, vol. 269, 937-948
- **H. M. DAHN** ; **A. SMITH** ; **J. BURNS** ; **D. STEVENS** ; **J. DAHN**. User-friendly differential voltage analysis freeware for the analysis of degradation mechanisms in li-ion batteries. *Journal of The Electrochemical Society*, 2012, vol. 159 (9), A1405-A1409
- **W. CHOI** ; **A. MANTHIRAM**. Comparison of metal ion dissolutions from lithium ion battery cathodes. *Journal of The Electrochemical Society*, 2006, vol. 153 (9), A1760-A1764
- **H. ZHENG** ; **Q. SUN** ; **G. LIU** ; **X. SONG** ; **V. S. BATTAGLIA**. Correlation between dissolution behavior and electrochemical cycling performance for lini1/3co1/3mn1/3o2-based cells. *Journal of Power Sources*, 2012, vol. 207, 134-140
- **T. WALDMANN** ; **M. WILKA** ; **M. KASPER** ; **M. FLEISCHHAMMER** ; **M. WOHLFAHRT-MEHRENS**. Temperature dependent ageing mechanisms in lithium-ion batteries-a post-mortem study. *Journal of Power Sources*, 2014, vol. 262, 129-135
- **J. SHIM** ; **R. KOSTECKI** ; **T. RICHARDSON** ; **X. SONG** ; **K. A. STRIEBEL**. Electrochemical analysis for cycle performance and capacity fading of a lithium-ion battery cycled at elevated temperature. *Journal of power sources*, 2002, vol. 112 (1), 222-230
- **K. JALKANEN** ; **J. KARPPINEN** ; **L. SKOGSTRÖM** ; **T. LAURILA** ; **M. NISULA** ; **K. VUORILEHTO**. Cycle aging of commercial NMC/graphite pouch cells at different temperatures. *Applied energy*, 2015, vol. 154, 160-172
- **O. DOLOTKO** ; **A. SENYSHYN** ; **M. MÜHLBAUER** ; **K. NIKOLOWSKI** ; **H. EHRENBERG**. Understanding structural changes in NMC Li-ion cells by in situ neutron diffraction. *Journal of Power Sources*, 2014, vol. 255, 197-203
- **Z. GUO** ; **X. QIU** ; **G. HOU** ; **B. Y. LIAW** ; **C. ZHANG**. State of health estimation for lithium ion batteries based on charging curves. *Journal of Power Sources*, 2014, vol. 249, 457-462
- **I. BLOOM** ; **A. N. JANSEN** ; **D. P. ABRAHAM** ; **J. KNUTH** ; **S. A. JONES** ; **V. S. BATTAGLIA** ; **G. L. HENRIKSEN**. Differential voltage analyses of high power, lithium-ion cells: 1. technique and application. *Journal of Power Sources*, 2005, vol. 139 (1-2), 295-303
- **M. DUBARRY** ; **C. TRUCHOT** ; **B. Y. LIAW**. Synthesize battery degradation modes via a diagnostic and prognostic model. *Journal of power sources*, 2012, vol. 219, 204-216
- **C. R. BIRKL** ; **E. MCTURK** ; **S. ZEKOLL** ; **F. H. RICHTER** ; **M. R. ROBERTS** ; **P. G. BRUCE** ; **D. A. HOWEY**. Degradation diagnostics for commercial lithium-ion cells tested at -10_c. *Journal of The Electrochemical Society*, 2017, vol. 164 (12), A2644-A2653
- **K. HONKURA** ; **H. HONBO** ; **Y. KOISHIKAWA** ; **T. HORIBA**. State analysis of lithium-ion batteries using discharge curves. *ECS Transactions*, 2008, vol. 13 (19), 61-73
- **M. DUBARRY** ; **M. BERECIBAR** ; **A. DEVIE** ; **D. ANSEÁN** ; **N. OMAR** ; **I. VILLARREAL**. State of health battery estimator enabling degradation diagnosis: Model and algorithm description. *Journal of Power Sources*, 2017, vol. 360, 59-69
- **J. DAHN**. Phase diagram of lixc6. *Physical Review B*, 1991, vol. 44 (17), 9170
- **I. BLOOM** ; **J. P. CHRISTOPHERSEN** ; **D. P. ABRAHAM** ; **K. L. GERING**. Differential voltage analyses of high-power lithium-ion cells: 3. another anode phenomenon. *Journal of power sources*, 2006, vol. 157 (1), 537-542
- Comparison of individual-electrode state of health estimation methods for lithium ion battery. **S. LEE** ; **J. B. SIEGEL** ; **A. G. STEFANOPOULOU** ; **J.-W. LEE** ; **T.-K. LEE**. ASME 2018 Dynamic Systems and Control Conference. American Society of Mechanical Engineers, 2018, V002T19A002-V002T19A002
- Beyond estimating battery state of health: Identifiability of individual electrode capacity and utilization. **S. LEE** ; **P. MOHTAT** ; **J. B. SIEGEL** ; **A. G. STEFANOPOULOU**. 2018 Annual American Control Conference (ACC). IEEE, 2018, 2288-2293
- **D. K. KARTHIKEYAN** ; **G. SIKHA** ; **R. E. WHITE**. Thermodynamic model development for lithium intercalation electrodes. *Journal of Power Sources*, 2008, vol. 185 (2), 1398-1407
- **S. G. STEWART** ; **V. SRINIVASAN** ; **J. NEWMAN**. Modeling the performance of lithium-ion batteries and capacitors during hybrid-electric vehicle operation. *Journal of The Electrochemical Society*, 2008, vol. 155 (9), A664-A671
- **M. SAFARI** ; **C. DELACOURT**. Modeling of a commercial graphite/lifepo4 cell. *Journal of the Electrochemical Society*, 2011, vol. 158 (5), A562-A571

- Battery Management Systems. **G. PLETT**. Battery Modeling. No. v. 1 in Artech House power engineering series. Artech House, 2015, vol. I
- **M. WOHLFAHRT-MEHRENS** ; **C. VOGLER** ; **J. GARCHE**. Aging mechanisms of lithium cathode materials. *Journal of power sources*, 2004, vol. 127 (1-2), 58-64
- **C. JULIEN** ; **A. MAUGER** ; **K. ZAGHIB** ; **H. GROULT**. Comparative issues of cathode materials for li-ion batteries. *Inorganics*, 2014, vol. 2 (1), 132-154
- **J. A. GILBERT** ; **J. BAREÑO** ; **T. SPILA** ; **S. E. TRASK** ; **D. J. MILLER** ; **B. J. POLZIN** ; **A. N. JANSEN** ; **D. P. ABRAHAM**. Cycling behavior of ncm523/graphite lithium-ion cells in the 3-4.4 v range: diagnostic studies of full cells and harvested electrodes. *Journal of The Electrochemical Society*, 2017, vol. 164 (1), A6054-A6065